# EUROPEAN PATENT APPLICATION

(11) **EP 4 443 494 A1**
(43) Date of publication of application: **09.10.2024**
(21) Application number: 24160841.3
(22) Date of filing: 01.03.2024
(51) Int. Cl.: H01L 23/473, H01L 23/367

(54) **HEAT DISSIPATING LID, CHIP PACKAGE STRUCTURE, AND DEVICE INTERCONNECTION SYSTEM**

(30) Priority: 03.03.2023 CN 202310248674
(71) Applicant: Huawei Technologies Co., Ltd., Shenzhen, Guangdong 518129 (CN)
(72) Inventor: QIU, Delong, Shenzhen, 518129 (CN); CHEN, Jinyu, Shenzhen, 518129 (CN); LU, Jun, Shenzhen, 518129 (CN); ZHENG, Jiantao, Shenzhen, 518129 (CN); LU, Jianbiao, Shenzhen, 518129 (CN); YOU, Xinyu, Shenzhen, 518129 (CN); ZUO, Rui, Shenzhen, 518129 (CN)
(74) Representative: Gill Jennings & Every LLP

(57) **Abstract**

Embodiments of this application disclose a heat dissipating lid, a chip package structure, and a device interconnection system, and relate to the field of semiconductor heat dissipation technologies, to improve reliability of heat dissipation for a chip and a capability of heat dissipation for the chip, and eliminate a local hotspot of the chip. The heat dissipating lid includes a bottom plate, a cover, and an intermediate partition plate. The cover is located on a side of the bottom plate, and is connected to the bottom plate. The intermediate partition plate is connected between the bottom plate and the cover. A lower-layer channel is provided between the intermediate partition plate and the bottom plate, an upper-layer channel is provided between the intermediate partition plate and the cover, the upper-layer channel includes a water inlet channel and a water outlet channel that are spaced from each other, the intermediate partition plate has a first opening and a second opening, the first opening connects the water inlet channel and the lower-layer channel, and the second opening connects the lower-layer channel and the water outlet channel. The heat dissipating lid is a 3D liquid-cooled heat dissipating lid. The upper-layer channel cooperates with the first opening, and is configured to distribute a flow of a cooling medium and divert the cooling medium to a specified cooling region. The lower-layer channel is configured to absorb heat dissipated from the chip.

## Description

### TECHNICAL FIELD

This application relates to the field of semiconductor heat dissipation technologies, and in particular, to a heat dissipating lid, a chip package structure, and a device interconnection system.

### BACKGROUND

As a quantity of cores and a speed of a chip increase, power consumption of the chip increases continuously. Consequently, a heat dissipation problem of the chip becomes one of bottlenecks that restrict chip development. Currently, an air-cooled heat dissipation technology or a liquid-cooled heat dissipation technology is usually used to dissipate heat for the chip.

However, currently, it is difficult for a common air-cooled heat dissipation technology to support power consumption higher than 1000 W. Currently, although a common liquid-cooled heat dissipation technology can resolve a problem of heat dissipation at power consumption from 1000 W to 2000 W, there are problems such as low reliability, an insufficient heat dissipation capability, and difficulty in eliminating a local hotspot of a chip.

### SUMMARY

Embodiments of this application provide a heat dissipating lid, a chip package structure, and a device interconnection system, to improve reliability of heat dissipation for a chip and a capability of heat dissipation for the chip, and eliminate a local hotspot of the chip.

To achieve the foregoing objectives, the following technical solutions are used in embodiments of this application.

According to a first aspect, a heat dissipating lid is provided, where the heat dissipating lid is used in a chip package structure, and is configured to dissipate heat for a chip. The heat dissipating lid includes a bottom plate, a cover, and an intermediate partition plate. The cover is located on a side of the bottom plate, and is connected to the bottom plate. The intermediate partition plate is connected between the bottom plate and the cover. A lower-layer channel is provided between the intermediate partition plate and the bottom plate, an upper-layer channel is provided between the intermediate partition plate and the cover, the upper-layer channel includes a water inlet channel and a water outlet channel that are spaced from each other, the intermediate partition plate has a first opening and a second opening, the first opening connects the water inlet channel and the lower-layer channel, and the second opening connects the lower-layer channel and the water outlet channel.

The heat dissipating lid provided in some embodiments of this application is a 3D liquid-cooled heat dissipating lid. Channels in the heat dissipating lid are classified into the lower-layer channel and the upper-layer channel that are disposed in a stacked manner, and the first opening and the second opening are provided in the intermediate partition plate, so as to connect the water inlet channel in the upper-layer channel and the lower-layer channel by using the first opening, and connect the lower-layer channel and the water outlet channel in the upper-layer channel by using the second opening. A quantity of the first openings and a disposing position of the first opening are adjusted, and the first opening cooperates with the water inlet channel, so that a flow of a cooling medium can be controlled, to increase or decrease the flow of the cooling medium, and diversion of a specified cooling region can be implemented.

When the heat dissipating lid is used in the chip package structure, a quantity of the first openings, an area of the first opening, or a disposing position of the first opening is adjusted, so that flow distribution of the cooling medium can be implemented, and the flow of the cooling medium in a local high power consumption region (which may also be referred to as a high heat flux density region) of the chip can be increased and adjusted, thereby effectively dissipating heat of a local hotspot of the chip, shortening an effective flow path of the cooling medium in a lower-layer channel, and improving a heat dissipation capability.

In a possible implementation of the first aspect, the water inlet channel includes a main water inlet path and at least one water inlet branch connected to the main water inlet path. The water outlet channel includes a main water outlet path and at least one water outlet branch connected to the main water outlet path. At least one first opening is provided on a part that is of the intermediate partition plate and that is opposite to the water inlet branch. At least one second opening is provided on a part that is of the intermediate partition plate and that is opposite to the water outlet branch. Different water inlet branches may correspond to different chips. In the foregoing disposition manner, a position at which the cooling medium flows into the lower-layer channel is further adjusted by using the water inlet branch, and the cooling medium is more accurately diverted to the specified cooling region. In addition, the flow of the cooling medium can be adjusted more accurately, so as to increase and adjust the flow of the cooling medium in different chips or in local high power consumption regions of different chips, and improve a local heat dissipation effect.

In a possible implementation of the first aspect, both the main water inlet path and the main water outlet path extend in a first direction and are disposed opposite to each other. Both the water inlet branch and the water outlet branch extend in a second direction and are located between the main water inlet path and the main water outlet path. The first direction and the second direction intersect, and both are parallel to a plane on which the intermediate partition plate is located. In the foregoing disposition manner, layout regularity of the main water inlet path, the main water outlet path, the water inlet branch, and the water outlet branch is improved, an area of an enclosed region is reduced, thereby avoiding increasing an area of the heat dissipating lid.

In a possible implementation of the first aspect, there are a plurality of the water outlet branches, and one water inlet branch is disposed between two adjacent water outlet branches in the first direction. The water outlet channel and the water inlet channel are at least arranged in a finger insertion structure.

In a possible implementation of the first aspect, the water inlet branch and the water outlet branch are disposed opposite to each other in the second direction, and there is a spacing between the water inlet branch and the water outlet branch.

In a possible implementation of the first aspect, the water inlet branch is connected to the at least one water outlet branch through the lower-layer channel.

In a possible implementation of the first aspect, the heat dissipating lid further includes at least one heat dissipation structure located in the lower-layer channel. The heat dissipation structure is connected to the bottom plate. Heat transfer may be performed between the heat dissipation structure and the bottom plate. Heat in the bottom plate may be directly diffused to the lower-layer channel, and may also be transferred to the heat dissipation structure and then diffused to the lower-layer channel by using the heat dissipation structure, thereby increasing a heat dissipation area.

In a possible implementation of the first aspect, the heat dissipation structure includes a heat sink, and the heat sink extends in a flow direction of a cooling medium in the lower-layer channel. In addition/alternatively, the heat dissipation structure includes a heat dissipation pin.

In a possible implementation of the first aspect, there are a plurality of the heat sinks, and the plurality of the heat sinks are arranged at intervals in a direction intersecting the flow direction of the cooling medium. Alternatively, there are a plurality of the heat dissipation pins, and the plurality of the heat dissipation pins are arranged in an array.

In a possible implementation of the first aspect, the heat dissipation structure and the bottom plate are in an integrated structure. This helps improve structural stability between the heat dissipation structure and the bottom plate, and facilitates assembly of the heat dissipating lid.

In a possible implementation of the first aspect, the heat dissipating lid further includes at least one thermal insulation structure located in the lower-layer channel, where the thermal insulation structure connects the bottom plate and the intermediate partition plate. The thermal insulation structure divides a part of the lower-layer channel around the thermal insulation structure into two flow channels. The thermal insulation structure has thermal insulation performance. This can prevent cooling media in two adjacent flow channels from performing heat exchange by using the thermal insulation structure, and prevent the cooling media in the two adjacent flow channels from performing heat crosstalk.

In a possible implementation of the first aspect, the thermal insulation structure is in a strip shape.

In a possible implementation of the first aspect, the thermal insulation structure includes a plurality of separators that connect the bottom plate and the intermediate partition plate. The plurality of separators are head-to-tail connected in sequence, to form an air gap between the bottom plate and the intermediate partition plate.

In a possible implementation of the first aspect, the plurality of separators are in an integrated structure. Alternatively, the plurality of separators and the bottom plate are in an integrated structure. This facilitates assembly of the heat dissipating lid.

According to a second aspect, a chip package structure is provided, where the chip package structure includes a chip and a heat dissipating lid. The heat dissipating lid covers the chip. The heat dissipating lid is the heat dissipating lid according to any implementation of the first aspect. A lower-layer channel in the heat dissipating lid covers at least a part of the chip.

The chip package structure provided in some embodiments of this application includes the heat dissipating lid. Therefore, a quantity of first openings in the heat dissipating lid, an area of the first opening, or a disposing position of the first opening is adjusted, so that flow distribution of the cooling medium can be implemented, the flow of the cooling medium in a local high power consumption region (which may also be referred to as a high heat flux density region) of the chip can be increased and adjusted, heat of a local hotspot of the chip can be effectively dissipated, and an effective flow path of the cooling medium in a lower-layer channel can be shortened, thereby improving a heat dissipation capability.

In addition, when the heat dissipating lid is used to dissipate heat for the chip, the cooling medium is accommodated in the heat dissipating lid, and the cooling medium does not directly contact the chip. Therefore, the cooling medium can be effectively prevented from dropping outside the chip, and reliability can be greatly improved.

In addition, a path from the chip to the lower-layer channel is short, and the heat dissipating lid directly covers the chip. Therefore, disposed water-cooled plates and second thermal interface material layers can be reduced, so that thermal resistance between the chip and the heat dissipating lid can be reduced, and a heat dissipation capability can be effectively improved, which is no longer limited by a heat dissipation capability of the water-cooled plate and heat transfer performance of the second thermal interface material layer.

Further, in this embodiment of this application, the heat dissipation capability is improved. This can prevent the chip from encountering temperature imbalance, thereby improving a series of reliability problems such as thermal stress and deformation of a material.

In a possible implementation of the second aspect, the water inlet branch is connected to the at least one water outlet branch through the lower-layer channel. In an orthographic projection onto a plane on which the intermediate partition plate is located, at least a part of the chip is located between the water inlet branch and the water outlet branch connected to the water inlet branch. In the foregoing disposition manner, a position at which the cooling medium flows into the lower-layer channel is further control, and the cooling medium is more accurately diverted to a specified cooling region, and flows from the specified cooling region to a specified water outlet branch. This effectively shortens an effective flow path of the cooling medium, and enables cooling media flowing through different chips to be different, thereby enabling cooling media in different regions to dissipate heat for different chips, and greatly improving a heat dissipation capability.

In a possible implementation of the second aspect, distribution density of the first opening is positively correlated with power consumption of the chip. The first opening is flexibly disposed, which helps improve flexibility and practicability of the heat dissipating lid and the chip package structure.

In a possible implementation of the second aspect, the heat dissipating lid further includes at least one heat dissipation structure located in the lower-layer channel, and the heat dissipation structure is connected to the bottom plate. In an orthographic projection onto a plane on which the intermediate partition plate is located, the heat dissipation structure partially overlaps the chip. The cooling medium in the lower-layer channel may contact the bottom plate, to absorb heat diffused from the bottom plate to the lower-layer channel, and may also contact the heat dissipation structure, to absorb heat diffused from the heat dissipation structure to the lower-layer channel. This effectively increases a heat exchange area, improves heat exchange efficiency, and helps greatly improve a capability of heat dissipation for the chip.

In a possible implementation of the second aspect, the power consumption of the chip is positively correlated with distribution density of the heat dissipation structure. In the foregoing disposition manner, when the power consumption of the chip is low and less heat is generated by the chip, the distribution density of the heat dissipation structure can be reduced, flow resistance can be reduced, a flow rate of the cooling medium can be increased, and a good capability of heat dissipation for the chip can be ensured. When the power consumption of the chip is high and more heat is generated by the chip, the distribution density of the heat dissipation structure can be increased, a heat exchange area can be increased, heat exchange efficiency can be improved, and effective heat dissipation for the chip with high power consumption and density can be ensured.

In a possible implementation of the second aspect, there are a plurality of the chips. The heat dissipating lid further includes at least one thermal insulation structure located in the lower-layer channel. The thermal insulation structure connects the bottom plate and the intermediate partition plate. In an orthographic projection onto a plane on which the intermediate partition plate is located, the thermal insulation structure is located between two adjacent chips, and the thermal insulation structure divides a part of the lower-layer channel corresponding to the two adjacent chips into different flow channels. The thermal insulation structure has thermal insulation performance. This can greatly reduce heat exchange of cooling media located above two adjacent chips by using the thermal insulation structure, and prevent thermal crosstalk between the two adjacent chips by using the heat dissipating lid.

In a possible implementation of the second aspect, the thermal insulation structure is in a strip shape, and an extension direction of the thermal insulation structure intersects an arrangement direction of the two adjacent chips.

In a possible implementation of the second aspect, the chip package structure further includes a package substrate, and the chip is located on the package substrate. A groove is provided on a side that is of the bottom plate and that faces the package substrate, the chip is located in the groove, and the bottom plate is connected to the package substrate. In this way, the chip can be protected, and large extrusion on the chip can be avoided.

According to a third aspect, a device interconnection system is provided, where the device interconnection system includes a circuit board and the chip package structure according to any implementation of the second aspect. The chip package structure is connected to the circuit board.

In a possible implementation of the third aspect, the device interconnection system further includes a cooling structure. The cooling structure is connected to a water inlet channel and a water outlet channel in a heat dissipating lid in the chip package structure.

For technical effects brought by any design manner in the third aspect, refer to the technical effects of different design manners in the second aspect. Details are not described herein again.

### BRIEF DESCRIPTION OF DRAWINGS

FIG. 1 is a diagram of a structure of a device interconnection system according to an embodiment of this application;
FIG. 2 is a diagram of a structure of a circuit board and a chip package structure according to an embodiment of this application;
FIG. 3a is a diagram of a structure including a package substrate, a chip, and a heat dissipating lid according to an embodiment of this application;
FIG. 3b is a top view of a structure of a heat dissipating lid according to an embodiment of this application;
FIG. 4 is a diagram of a structure including a package substrate, a chip, a heat dissipating lid, a first thermal interface material layer, a second thermal interface material layer, and a water-cooled plate according to an embodiment of this application;
FIG. 5 is a top view of a structure of a heat dissipating lid according to an embodiment of this application;
FIG. 6 is a diagram of a split structure of a heat dissipating lid according to an embodiment of this application;
FIG. 7 is a sectional view of a structure of the heat dissipating lid shown in FIG. 5 in a K-K' direction;
FIG. 8 is a diagram of a structure of a chip package structure according to an embodiment of this application;
FIG. 9 is a diagram of a structure of another device interconnection system according to an embodiment of this application;
FIG. 10 is a top view of a structure of a chip package structure according to an embodiment of this application;
FIG. 11 is a top view of a structure of another heat dissipating lid according to an embodiment of this application;
FIG. 12 is a top view of a structure of still another heat dissipating lid according to an embodiment of this application;
FIG. 13 is a top view of a structure of yet another heat dissipating lid according to an embodiment of this application;
FIG. 14 is a top view of a structure of another chip package structure according to an embodiment of this application;
FIG. 15 is a top view of a structure of still another chip package structure according to an embodiment of this application;
FIG. 16 is a top view of a structure of still yet another chip package structure according to an embodiment of this application;
FIG. 17 is a top view of a structure of still yet another heat dissipating lid according to an embodiment of this application;
FIG. 18 is a sectional view of a structure of the heat dissipating lid shown in FIG. 17 in an L-L' direction;
FIG. 19 is a diagram of a structure including a bottom plate and a heat dissipation structure according to an embodiment of this application;
FIG. 20 is a top view of a structure of a further chip package structure according to an embodiment of this application;
FIG. 21 is a sectional view of a structure of the chip package structure shown in FIG. 20 in an M-M' direction;
FIG. 22 is a diagram of a structure of still another device interconnection system according to an embodiment of this application;
FIG. 23 is a top view of a structure of a still further chip package structure according to an embodiment of this application;
FIG. 24 is a top view of a structure of a yet further chip package structure according to an embodiment of this application;
FIG. 25 is a top view of a structure of a still yet further chip package structure according to an embodiment of this application;
FIG. 26 is a sectional view of a structure of the chip package structure shown in FIG. 25 in an N-N' direction;
FIG. 27 is a diagram of a structure of a thermal insulation structure according to an embodiment of this application;
FIG. 28 is a diagram of a structure corresponding to each step of preparing a bottom plate according to an embodiment of this application;
FIG. 29 is a top view of a structure of a bottom plate according to an embodiment of this application;
FIG. 30 is a diagram of a structure corresponding to each step of preparing an intermediate partition plate according to an embodiment of this application;
FIG. 31 is a diagram of a structure of a cover according to an embodiment of this application;
FIG. 32 is a diagram of a structure of an assembled bottom plate and intermediate partition plate according to an embodiment of this application;
FIG. 33 is a diagram of a structure of an assembled bottom plate, intermediate partition plate, and cover according to an embodiment of this application;
FIG. 34 is a diagram of a structure including a package substrate, a chip, a first thermal interface material layer, an adhesive layer, and a heat dissipating lid according to an embodiment of this application; and
FIG. 35 is a diagram of a structure of an assembled package substrate, chip, first thermal interface material layer, adhesive layer, and heat dissipating lid according to an embodiment of this application.

### DESCRIPTION OF EMBODIMENTS

The following describes technical solutions in embodiments of this application with reference to accompanying drawings in embodiments of this application. It is clear that the described embodiments are merely some but not all of embodiments of this application. All other embodiments obtained by a person of ordinary skill in the art based on embodiments of this application fall within the protection scope of this application.

In the descriptions of embodiments of this application, "a plurality of" means two or more, unless otherwise specified. "At least one item (piece)" or a similar expression thereof indicates any combination of these items, including a single item (piece) or any combination of a plurality of items (pieces). For example, at least one item (piece) of a, b, and c may represent a, b, c, a-b, a-c, b-c, or a-b-c, where a, b, and c may be singular or plural.

"And/or" describes an association relationship between associated objects, and indicates that three relationships may exist. For example, a and/or b may indicate the following cases: Only a exists, both a and b exist, and only b exists, where a and b may be singular or plural. The character "/" generally indicates an "or" relationship between the associated objects.

In addition, to clearly describe the technical solutions in embodiments of this application, terms such as first and second are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, the word such as "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" are intended to present a related concept in a specific manner for ease of understanding.

In the description of some embodiments, expressions of "connection" and extensions thereof are used. The term "connection" should be understood in a broad sense. For example, the "connection" may be a fixed connection, a detachable connection, or an integrated connection, or may be a direct connection or an indirect connection implemented through an intermediate medium. In addition, the use of "based on" means openness and inclusiveness, since processes, steps, calculation, or other actions "based on" one or more of conditions or values may be based in practice on additional conditions or values outside the described values.

In embodiments of this application, orientation terms such as "upper" and "lower" may include but are not limited to being defined relative to placement orientations of components shown in the accompanying drawings. It should be understood that these directional terms may be relative concepts and are used for relative descriptions and clarifications, and may vary accordingly based on changes of the placement orientations of the components in the accompanying drawings. In the accompanying drawings, for clarity, thicknesses of layers and regions are exaggerated, and a size proportion relationship between parts in the figures does not reflect an actual size proportion relationship. Thus, a change in a shape in the accompanying drawings due to, for example, manufacturing techniques and/or tolerances may be envisaged. Therefore, example implementations should not be construed as being limited to a shape of a region shown in this application, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

The technical solutions provided in embodiments of this application may be applied to various device interconnection systems including a chip. For example, an embodiment of this application provides a device interconnection system. The device interconnection system may be a super computer, a vehicle-mounted device, a smart home device and/or a smart city device, a server, a workstation, a data center, or the like. A specific type of the device interconnection system is not specially limited in embodiments of this application.

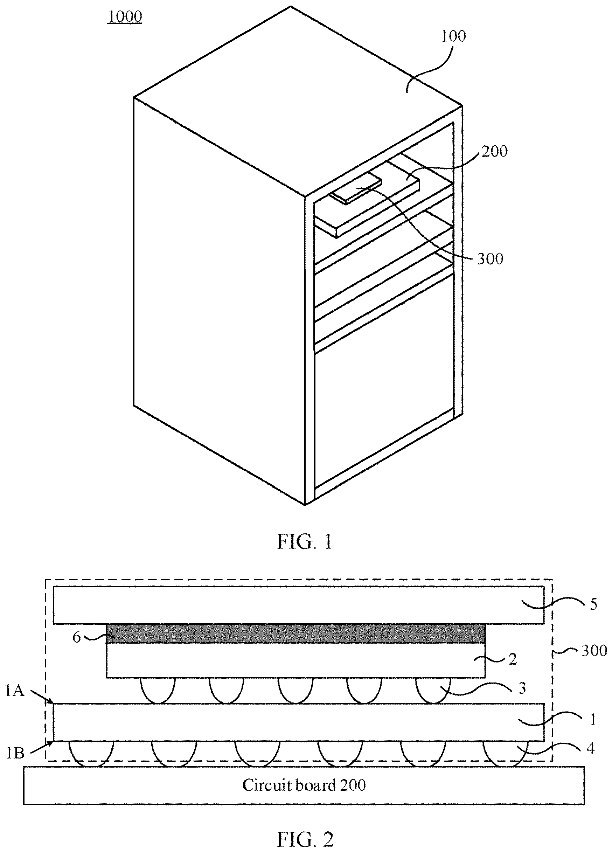

For ease of description, the following uses an example in which the device interconnection system is a server for description, which cannot be considered as a specific limitation on a structure form of the device interconnection system. FIG. 1 is a diagram of a structure of a server according to some embodiment.

As shown in FIG. 1, a device interconnection system 1000 includes a cabinet 100, a circuit board 200 disposed in the cabinet 100, and a chip package structure 300 connected to the circuit board 200. The circuit board 200 includes but is not limited to a printed circuit board (printed circuit board, PCB).

FIG. 2 shows structures of the circuit board 200 and the chip package structure 300. As shown in FIG. 2, the chip package structure 300 includes a package substrate 1 and a chip 2. The package substrate 1 has a first surface 1A and a second surface 1B that are opposite to each other, the chip 2 is located on the first surface 1A, and the circuit board 200 is located on the second surface 1B.

Still refer to FIG. 2. The chip package structure 300 further includes a first connecting piece 3 disposed between the chip 2 and the first surface 1A, and the chip 2 is connected (or soldered) to the package substrate 1 by using the first connecting piece 3. The first connecting piece 3 is, for example, a controlled collapse chip connection bump (controlled collapse chip connection bump, C4 bump). The chip package structure 300 further includes a second connecting piece 4 disposed between the circuit board 200 and the second surface 1B, and the printed circuit board 500 is connected (or soldered) to the package substrate 1 by using the second connecting piece 4. The second connecting piece 4 may be, for example, a solder ball.

The package substrate 1 includes, for example, a plurality of layers of cables. The chip 2 may be electrically connected to the cables in the package substrate 1 by using the first connecting piece 3, and the cables in the package substrate 1 may also be electrically connected to the circuit board 200 by using the second connecting piece 4. In this way, the chip package structure 300 can be electrically connected to the circuit board 200.

Optionally, the package substrate 1 includes but is not limited to an organic substrate, a ceramic substrate, and a silicon substrate. A plurality of passive devices may be disposed on the first surface 1A of the package substrate 1.

In some embodiments of this application, the chip 2 may be a wafer (wafer) that has a function layer, or may be a die (die) obtained by cutting a wafer that has a function layer. The die may also be referred to as a grain or a particle. In some cases, the chip 2 may alternatively be a chip obtained by packaging the die. Based on this, in some embodiments, the plurality of chips 2 in the chip package structure 300 may all be dies or chips obtained by packaging the dies. In some other embodiments, the plurality of chips 2 in the chip package structure 300 may all be wafers. In some other embodiments, in the plurality of chips 2 in the chip package structure 300, some chips 2 may be wafers, and some chips 2 may be dies and/or chips obtained by packaging the dies.

For example, the function layer enables the chip 2 to implement a storage function, and correspondingly, the chip 2 is a memory chip. For another example, the function layer enables the chip 2 to implement a logical computing function, and correspondingly, the chip 2 is a processor chip.

Still refer to FIG. 2. The chip package structure 300 further includes a heat dissipating lid (heat dissipating lid, HDL) 5 and a first thermal interface material (thermal interface material, TIM) layer 6. The heat dissipating lid 5 covers the chip 2, so that the chip 2 can be protected, and heat generated by the chip 2 can be diffused, thereby cooling the chip 2, and ensuring normal running of the chip 2. The first thermal interface material layer 6 is connected between the chip 2 and the heat dissipating lid 5. The first thermal interface material layer 6 can effectively reduce thermal contact resistance between the chip 2 and the heat dissipating lid 5, and further improve heat dissipation performance for the chip 2.

There may be one or more chips 2. FIG. 2 shows one chip 2. It may be understood that, when there are a plurality of chips 2, the plurality of chips 2 may be sequentially stacked in a direction perpendicular to the first surface 1A, or may be tiled on the first surface 1A.

The chip package structure 300 may be applied to, for example, 2.5D packaging, 3D packaging, and the like. When the chip package structure 300 is applied to 2.5D packaging, the chip package structure 300 further includes, for example, a silicon intermediate board (which may also be referred to as a rewiring layer) located between the chip 2 and the package substrate 1. When the chip package structure 300 is applied to 3.5D packaging, there are a plurality of chips 2, and the plurality of chips 2 may be sequentially stacked in the direction perpendicular to the first surface 1A. In this case, at least one chip 2 may be disposed between the chip 2 closest to the heat dissipating lid 5 and the package substrate 1. In other words, the chip 2 closest to the heat dissipating lid 5 is directly located on the remaining chips 2, but not directly located on the package substrate 1.

When there are a plurality of chips 2, in this embodiment of this application, an example in which the plurality of chips 2 are tiled on the first surface 1A is used for description below.

It may be understood that the device interconnection system 1000 is usually large. As a quantity of cores and an operation speed of the chip increase, power consumption of the device interconnection system 1000 and heat dissipated from the device interconnection system 1000 also increase, which poses a challenge to a liquid-cooled heat dissipation technology. Currently, common liquid-cooled heat dissipation technologies generally include an impact jet flow liquid-cooled technology, a microfluidic channel liquid-cooled technology, and a liquid-cooled plate technology. The impact jet flow liquid-cooled technology is generally applied to a chip package structure 300 in which no heat dissipating lid 5 and no first thermal interface material layer 6 are disposed, and the microfluidic channel liquid-cooled technology and the liquid-cooled plate technology are generally applied to a chip package structure 300 in which the heat dissipating lid 5 and the first thermal interface material layer 6 are disposed.

When the impact jet flow liquid-cooled technology is used to dissipate heat for the chip 2, a cooling medium (namely, a coolant) needs to be directly jetted to an upper surface of the chip 2, and the coolant directly contacts the chip 2, and effectively takes away heat generated by the chip 2. The impact jet flow liquid-cooled technology is more effective in cooling high heat flux density and high power consumption chips. However, after the coolant is jetted to the upper surface of the chip 2, the coolant inevitably drops outside the chip 2, for example, drops to the package substrate 1 and another structure (including but not limited to a structure made of a moisture-absorbing material, for example, a plastic packaging material or an adhesive material), which greatly reduces reliability.

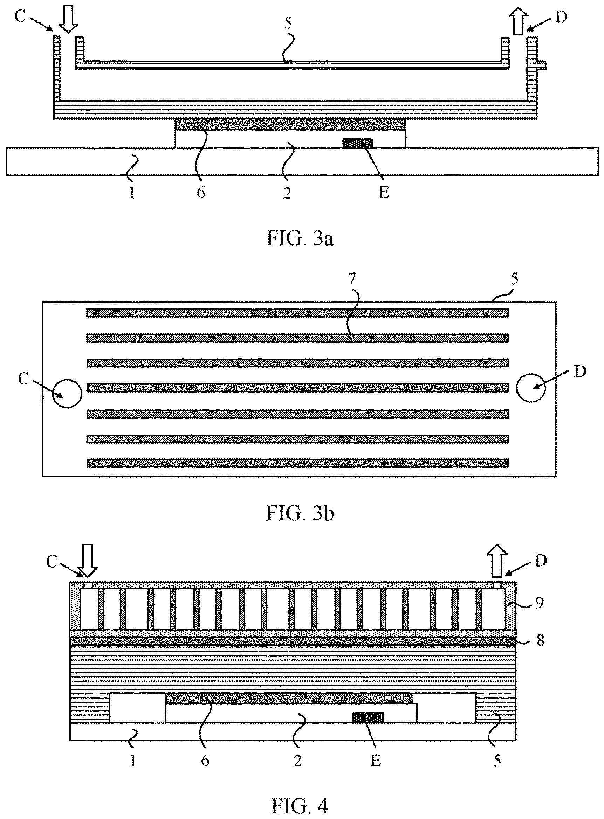

FIG. 3a shows a structure including the package substrate 1, the chip 2, and the heat dissipating lid 5. FIG. 3b shows a top-view structure of the heat dissipating lid 5. The heat dissipating lid 5 has a fluid cavity, and a plurality of fins 7 disposed side by side are disposed in the fluid cavity, so as to form a plurality of liquid-cooled microfluidic channels (liquid-cooled microfluidic channel, LMC). In this case, the heat dissipating lid 5 may also be referred to as a micro-fluidic channel lid (micro-fluidic channel lid, MCL). The heat dissipating lid 5 is further provided with an inlet C and an outlet D that are connected to the fluid cavity. When the microfluidic channel liquid-cooled technology is used to dissipate heat for the chip 2, the coolant flows into the liquid-cooled microfluidic channel from the inlet C, so that the coolant is as close as possible to a heat source of the chip, and flows out from the outlet D, to take away heat generated by the chip 2. However, a flow path of the heat dissipating lid 5 is long, and flow resistance is large. In addition, when the coolant flows in the liquid-cooled microfluidic channel, the coolant absorbs heat and is heated. In a flow direction, a temperature of the heat source of the chip gradually increases, and a heat dissipation capability is gradually reduced. In addition, a flow of the coolant in the high power consumption region of the chip 2 cannot be locally increased and adjusted, and it is difficult to eliminate a local hotspot E of the chip. In addition, due to the reduced heat dissipation capability, the chip encounters temperature imbalance, which causes a series of reliability problems such as thermal stress and deformation of a material.

FIG. 4 shows a structure including the package substrate 1, the chip 2, the heat dissipating lid 5, the first thermal interface material layer 6, a second thermal interface material layer 8, and a water-cooled plate 9. The water-cooled plate 9 is located on the heat dissipating lid 5, and the second thermal interface material layer 8 is connected between the heat dissipating lid 5 and the water-cooled plate 9. The water-cooled plate 9 has a fluid cavity, and the water-cooled plate 9 is further provided with an inlet C and an outlet D that are connected to the fluid cavity. When the liquid-cooled plate technology is used to dissipate heat for the chip 2, the coolant flows into the flow cavity from the inlet C, and flows out from the outlet D, to take away heat generated by the chip 2. Because the chip 2 and the water-cooled plate 9 need to be connected by using the first thermal interface material layer 6 and the second thermal interface material layer 8, a heat dissipation capability supported by the liquid-cooled plate technology is not only limited by a heat dissipation capability of the water-cooled plate 9, but also limited by heat transfer performance of the thermal interface material. As a result, the heat dissipation capability is insufficient. In addition, the flow of the coolant in the high power consumption region of the chip 2 cannot be locally increased and adjusted, and it is difficult to effectively dissipate heat for the local hotspot E of the chip.

Based on this, some embodiments of this application provide a heat dissipating lid, a chip package structure to which the heat dissipating lid is applied, and a device interconnection system to which the chip package structure is applied. With reference to the accompanying drawings, the following schematically describes the heat dissipating lid, the chip package structure to which the heat dissipating lid is applied, and the device interconnection system to which the chip package structure is applied.

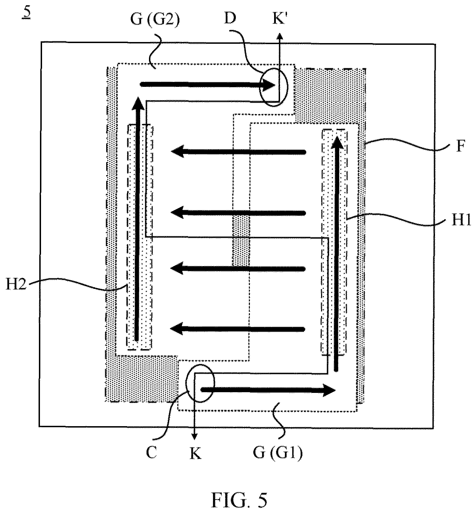

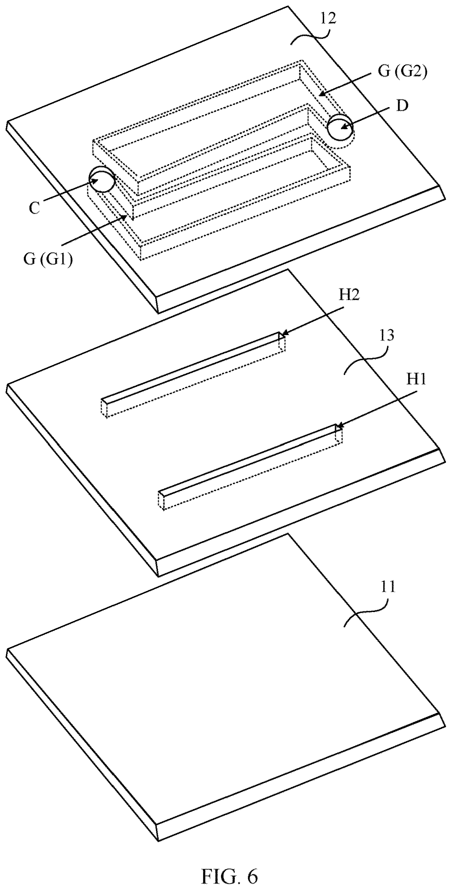

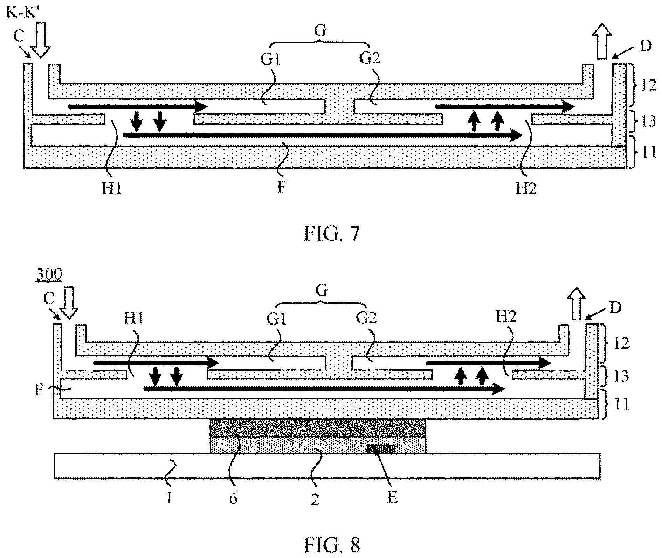

FIG. 5 shows a top-view structure of the heat dissipating lid 5, FIG. 6 shows a split structure of the heat dissipating lid, and FIG. 7 shows a sectional view structure of the heat dissipating lid. With reference to FIG. 5 to FIG. 7, the heat dissipating lid 5 includes a bottom plate 11, a cover 12, and an intermediate partition plate 13. The cover 12 is located on a side of the bottom plate 11, and is connected to the bottom plate 11. The intermediate partition plate 13 is connected between the bottom plate 11 and the cover 12. A lower-layer channel F is provided between the intermediate partition plate 13 and the bottom plate 11, and an upper-layer channel G is provided between the intermediate partition plate 13 and the cover 12.

The upper-layer channel G includes a water inlet channel G1 and a water outlet channel G2 that are spaced from each other. The water inlet channel G1 and the water outlet channel G2 are independent of each other. The water inlet channel G1 and the water outlet channel G2 are not directly connected, and a cooling medium in the water inlet channel G1 cannot directly flow into the water outlet channel G2.

The intermediate partition plate 13 has a first opening (opening) H1 and a second opening H2, where the first opening H1 and the second opening H2 are separated from each other, the first opening H1 connects the water inlet channel G1 and the lower-layer channel F, and the second opening H2 connects the lower-layer channel F and the water outlet channel G2. In other words, the water inlet channel G1 may be connected to the water outlet channel G2 through the first opening H1, the lower-layer channel F, and the second opening H2 in sequence.

Optionally, an inlet C and an outlet D are provided on the cover 12, the inlet C is connected to the water inlet channel G1, and the outlet D is connected to the water outlet channel G2. In this way, as shown by an arrow in FIG. 7, the cooling medium may flow into the water inlet channel G1 through the inlet C, then flow into the lower-layer channel F through the first opening H1, flow into the water outlet channel G2 through the second opening H2, and finally flow out of the heat dissipating lid 5 through the outlet D.

As shown in FIG. 8, when the heat dissipating lid 5 covers the chip 2, the cover 12 is located on a side that is of the bottom plate 11 and that is away from the chip 2. Compared with the upper-layer channel G, the lower-layer channel F is closer to the chip 2, and the lower-layer channel F covers at least a part of the chip 2. In this way, heat generated by the chip 2 is diffused to the lower-layer channel F through the bottom plate 11, is absorbed by the cooling medium flowing into the lower-layer channel F, and is discharged from the water outlet channel G2 and the outlet D along with the cooling medium, thereby implementing heat dissipation for the chip 2. The heat dissipating lid 5 may also be referred to as a 3D liquid-cooled heat dissipating lid.

A material of the bottom plate 11 includes a material with high thermal conductivity, for example, a metal material (including but not limited to copper and aluminum). This helps reduce thermal resistance and enhance heat transfer from the chip 2 to the lower-layer channel F. Materials of the cover 12 and the intermediate partition plate 13 may be the same as or different from the material of the bottom plate 11. Optionally, materials of the bottom plate 11, the cover 12, and the intermediate partition plate 13 are all metal materials.

In the intermediate partition plate 13, there may be one, two, three, or more first openings H1. FIG. 5 shows one first opening H1. An area of the first opening H1 may be selected based on an actual requirement. There may be one, two, three, or more second openings H2. FIG. 5 shows one second opening H2.

The cooling medium in embodiments of this application may be liquid, including but not limited to water or other cooling liquid. Alternatively, in embodiments of this application, the cooling medium in the inlet C and the water inlet channel G1 is liquid, and after absorbing heat in the lower-layer channel F, the cooling medium becomes gas and flows out from the water outlet channel G2 and the outlet D.

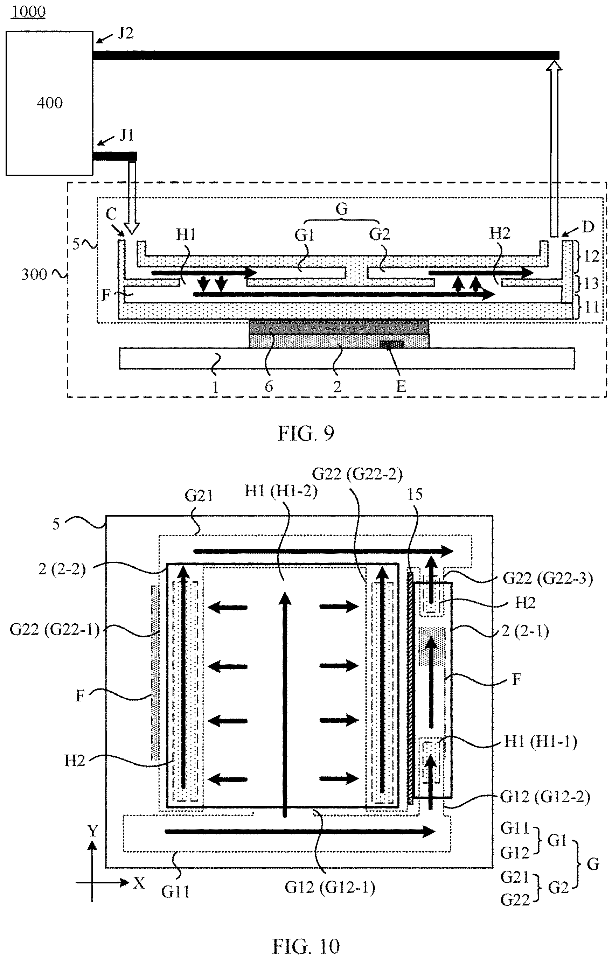

In a device interconnection system 1000 shown in FIG. 9, a cooling structure 400 and a chip package structure 300 are shown. The chip package structure 300 includes the package substrate 1, the chip 2 connected to the package substrate 1, and the heat dissipating lid 5 located on the chip 2. The heat dissipating lid 5 covers the chip 2. The bottom plate 11 in the heat dissipating lid 5 is connected to the chip 2 by using, for example, the first thermal interface material layer 6. The cover 12 is located on a side that is of the bottom plate 11 and that is away from the chip 2, so that the upper-layer channel G is located on a side that is of the lower-layer channel F and that is away from the chip 2, and the lower-layer channel F covers at least a part of the chip 2. Optionally, the lower-layer channel F may completely cover the chip 2. Alternatively, the lower-layer channel F may cover only a part of the chip 2. For example, the part of the chip 2 covered by the lower-layer channel F is a local high power consumption region or a local hotspot E of the chip 2. In a case in which the lower-layer channel F covers the local high power consumption region or the local hotspot E of the chip 2, the cooling medium may be transmitted to the local high power consumption region or the local hotspot E of the chip 2 in a more centralized manner, so as to perform targeted heat dissipation for the chip 2.

The cooling structure 400 is, for example, a coolant distribution unit (CDU). Still refer to FIG. 9. The cooling structure 400 has a first port J1 and a second port J2. The first port J1 is connected to the inlet C on the cover 12 through a corresponding pipe, so as to implement connection between the cooling structure 400 and the water inlet channel G1. The second port J2 is connected to the outlet D on the cover 12 through a corresponding pipe, so as to implement connection between the cooling structure 400 and the water outlet channel G2. The cooling structure 400 is configured to perform refrigeration and cooling on the cooling medium that flows through the lower-layer channel F and the water outlet channel G2, and transmit the cooling medium with a lower temperature to the water inlet channel G1 and the lower-layer channel F, so as to circulate flow of the cooling medium, thereby achieving a better heat dissipation effect.

It may be understood that a flow of the cooling medium flowing into the lower-layer channel F and a position of the cooling medium flowing into the lower-layer channel F are related to the first opening H1.

In a case in which a quantity of first openings H1 is small or the area of the first opening H1 is small, the flow of the cooling medium flowing into the lower-layer channel F from the water inlet channel G1 is small. In a case in which the quantity of first openings H1 is large or the area of the first opening H1 is large, the flow of the cooling medium flowing into the lower-layer channel F from the water inlet channel G1 is large. In other words, the quantity of the first openings H1 or the area of the first opening H1 is adjusted, so that the first openings H1 can cooperate with the water inlet channel G1 to control the flow of the cooling medium, and the flow of the cooling medium can be increased or decreased based on a heat dissipation requirement.

A disposing position of the first opening H1 may include a plurality of cases. Optionally, in the top-view structure shown in FIG. 10, two first openings H1 (namely, first openings H1-1 and H1-2) and two chips 2 (namely, chips 2-1 and 2-2) are shown. For example, the first opening H1-1 is located at one end of the chip 2-1. In this case, the cooling medium may flow into the lower-layer channel F from a region in which the one end of the chip 2-1 is located, flow from the one end of the chip 2-1 to the other opposite end, and flow out from the second opening H2, to take away heat generated by the chip 2-1. For another example, the first opening H1-2 is located in a middle part of the chip 2-2. In this case, the cooling medium may flow into the lower-layer channel F from a region in which the middle part of the chip 2-2 is located. The cooling medium may be divided into two parts. One part of the cooling medium may flow to the left side shown in FIG. 10, flow from the middle part of the chip 2-2 to a left side of the chip 2, and flow out from the second opening H2 located on the left side, to take away heat generated in a left region of the chip 2-2. The other part of the cooling medium may flow to the right side shown in FIG. 10, flow from the middle part of the chip 2-2 to a right side of the chip 2-2, and flow out from the second opening H2 located on the right side, to take away heat generated in a right region of the chip 2. In other words, the disposing position of the first opening H1 is adjusted, so that a position at which the cooling medium flows into the lower-layer aisle F can be adjusted, so as to implement diversion of a specified cooling region.

This means that in an embodiment of this application, the quantity of the first openings H1 or the area of the first opening H1 is adjusted, and the disposing position of the first opening H1 is adjusted, so that flow distribution of the cooling medium can be implemented, the flow of the cooling medium in a local high power consumption region (which may also be referred to as a high heat flux density region) of the chip 2 can be increased and adjusted, heat of the local hotspot E of the chip 2 can be effectively dissipated, and an effective flow path of the cooling medium in the lower-layer channel F can be shortened, thereby improving a heat dissipation capability.

Further, the disposing position of the first opening H1 is adjusted, so that a flow path of the cooling medium in the lower-layer channel F can be adjusted, thereby effectively shortening the flow path. No fin is disposed on the upper-layer channel G and the lower-layer channel F. In this way, flow resistance in the upper-layer channel G and the lower-layer channel F can be effectively reduced.

In addition, it can be seen from FIG. 8 and FIG. 9 that, when the heat dissipating lid 5 is used to dissipate heat for the chip 2, the cooling medium is accommodated in the heat dissipating lid 5, and the thermal interface material layer 6 and the bottom plate 11 are disposed at an interval between the cooling medium and the chip 2. Therefore, compared with the impact jet flow liquid-cooled technology, the cooling medium can be effectively prevented from directly contacting the chip 2, and the cooling medium can be prevented from dropping outside the chip 2, thereby greatly improving reliability.

In addition, a path from the chip 2 to the lower-layer channel F is short, and the heat dissipating lid 5 directly covers the chip 2. Compared with the liquid-cooled plate technology, disposed water-cooled plates and second thermal interface material layers can be reduced, so that thermal resistance between the chip 2 and the heat dissipating lid 5 can be reduced, and a heat dissipation capability can be effectively improved, which is no longer limited by a heat dissipation capability of the water-cooled plate 9 and heat transfer performance of the second thermal interface material layer.

Further, in this embodiment of this application, the heat dissipation capability is improved. This can prevent the chip 2 from encountering temperature imbalance, thereby improving a series of reliability problems such as thermal stress and deformation of a material.

In some embodiments, distribution density of the first opening H1 is positively correlated with power consumption of the chip 2. In other words, lower power consumption of the chip 2 indicates lower distribution density of the first opening H1, and higher power consumption of the chip 2 indicates higher distribution density of the first opening H1.

The "distribution density of the first opening H1" is, for example, a distribution quantity of the first openings H1 per unit area, or an area proportion of the first opening H1 per unit area. Correspondingly, as the power consumption of the chip 2 increases, the distribution quantity of the first openings H1 or the area proportion of the first opening H1 gradually increases per unit area. As the power consumption of the chip 2 decreases, the distribution quantity of the first openings H1 or the area proportion of the first opening H1 gradually decreases per unit area.

The quantity of the first openings H1 or the area of the first opening H1 can cooperate with the water inlet channel G1, to control the flow of the cooling medium. Therefore, in the foregoing disposition manner, the distribution density of the first openings H1 can be reduced when the power consumption of the chip 2 is low and less heat is generated, so as to reduce the flow of the cooling medium, thereby implementing heat dissipation for the chip 2 and reducing costs; and the distribution density of the first openings H1 can be increased when the power consumption of the chip 2 is high and more heat is generated, so as to increase the flow of the cooling medium, thereby implementing effective heat dissipation for the chip 2.

In this embodiment of this application, the first opening H1 is flexibly disposed, which helps improve flexibility and practicability of the heat dissipating lid 5 and the chip package structure 300.

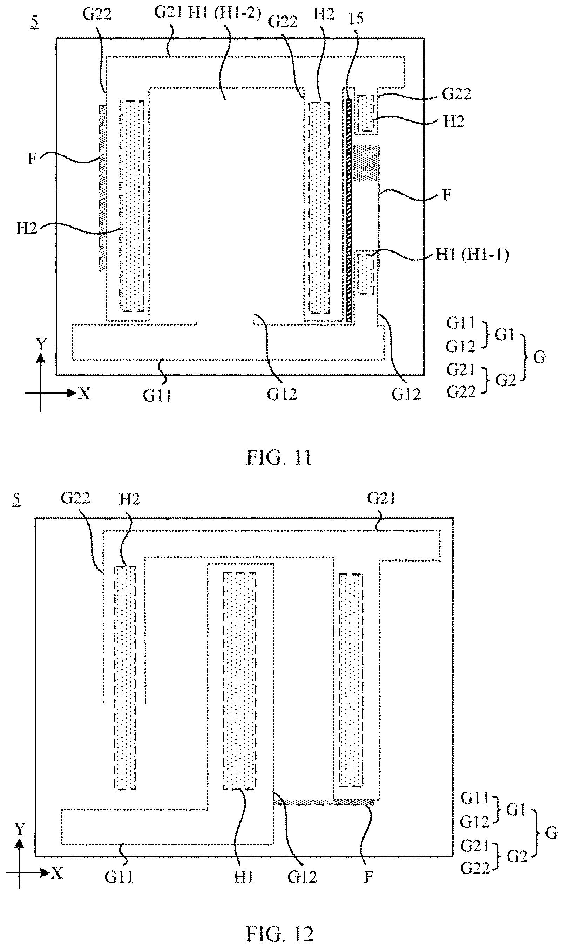

In the heat dissipating lid 5, there are a plurality of manners of disposing the water inlet channel G1 and the water outlet channel G2, and the manner may be selected based on an actual requirement. FIG. 11, FIG. 12, and FIG. 13 respectively show structures of the heat dissipating lid 5.

In some embodiments, as shown in FIG. 11 to FIG. 13, the water inlet channel G1 includes a main water inlet path G11 and at least one water inlet branch G12 connected to the main water inlet path G11.

Optionally, there may be one, two, three, or more water inlet branches G12, and a quantity of the water inlet branches G12 may be set based on a quantity of chips 2 and heat dissipation requirements of different chips 2. When there are a plurality of water inlet branches G12, for example, the water inlet channels G1 are distributed in a manifold shape, and the water inlet branches G12 are separated from each other and are not directly connected. Optionally, the plurality of water inlet branches G12 may be disposed side by side, and lengths of different water inlet branches G12 may be the same or may be different.

At least one first opening H1 is provided on a part that is of the intermediate partition plate 13 and that is opposite to each water inlet branch G12. For example, one, two, three, or more first openings H1 are provided on the part that is of the intermediate partition plate 13 and that is opposite to each water inlet branch G12.

In this way, each water inlet branch G12 may be connected to the lower-layer channel F by using a corresponding first opening H1. The cooling medium may first flow into the main water inlet path G11 through the inlet C, then flow into different water inlet branches G12 separately, and flow into the lower-layer channel F through the first opening H1 corresponding to each water inlet branch G12. When the heat dissipating lid 5 covers the chip 2, the cooling medium flowing into the lower-layer channel F may absorb heat generated by the chip 2. For example, different water inlet branches G12 may correspond to different chips 2.

The water inlet channel G1 is designed to obtain the main water inlet path G11 and the water inlet branch G12 through division, which helps further adjust, by using the water inlet branch G12, a position at which the cooling medium flows into the lower-layer channel F, more accurately divert the cooling medium to a specified cooling region, and more accurately adjust a flow of the cooling medium, to increase and adjusting the flow of the cooling medium in different chips 2 or local high-power consumption regions of the chips 2, and improve a local heat dissipation effect.

In some embodiments, as shown in FIG. 11 to FIG. 13, the water outlet channel G2 includes a main water outlet path G21 and at least one water outlet branch G22 connected to the main water outlet path G21.

Optionally, there may be one, two, three, or more water outlet branches G22, and a quantity of the water outlet branches G22 may be set based on a flow requirement and a flow direction requirement of the cooling medium in the lower-layer channel F. When there are a plurality of water outlet branches G22, for example, the water outlet channels G2 are distributed in a manifold shape, and the water outlet branches G22 are separated from each other and are not directly connected. Optionally, the plurality of water outlet branches G22 may be disposed side by side, and lengths of different water outlet branches G22 may be the same or may be different.

At least one second opening H2 is provided on a part that is of the intermediate partition plate 13 and that is opposite to each water outlet branch G22. For example, one, two, three, or more second openings H2 are provided on the part that is of the intermediate partition plate 13 and that is opposite to each water outlet branch G22.

In this way, each water outlet branch G22 may be connected to the lower-layer channel F by using a corresponding second opening H2. The cooling medium in the lower-layer channel F may flow into corresponding water outlet branches G12 through different second openings H12, be converged to the main water outlet path G21, and flow out from the outlet D.

In the foregoing embodiment, a main water inlet path G11 and a main water outlet path G21 are disposed, so that only one inlet C connected to the main water inlet path G11 and only one outlet D connected to the main water outlet path G21 are disposed on the cover. In this way, in the device interconnection system 1000, the first port J1 of the cooling structure 400 may be connected to only one inlet C, and transmit the cooling medium to the water inlet G1 through the one inlet C, and the second port J2 of the cooling structure 400 may be connected to only one outlet D, and recycle the cooling medium from the water outlet G2 through the one outlet D. This helps simplify connection between the cooling structure 400 and the heat dissipating lid 5, and facilitates control of the cooling medium.

In the foregoing embodiment, no opening H is provided on a part that is of the intermediate partition plate 13 and that is opposite to the main water inlet path G11 and the main water outlet path G21, that is, the main water inlet path G11, the main water outlet path G21, and the lower-layer channel F are not directly connected.

In some examples, as shown in FIG. 11 to FIG. 13, both the main water inlet path G11 and the main water outlet path G21 extend in a first direction X and are disposed opposite to each other. Both the water inlet branch G12 and the water outlet branch G22 extend in a second direction Y and are located between the main water inlet path G11 and the main water outlet path G12.

For example, the first direction X and the second direction Y intersect, and both are parallel to the first surface 1A. Herein, for example, a plane on which the intermediate partition plate 13 is located is parallel to the first surface 1A. Correspondingly, the first direction X and the second direction Y are also parallel to the plane on which the intermediate partition plate 13 is located. Optionally, an included angle between the first direction X and the second direction Y may be but not limited to 85°, 88°, 89°, 90°, or the like. In the figure, an example in which the included angle between the first direction X and the second direction Y is 90° is used for description.

Optionally, the main water inlet path G11, the main water outlet path G21, the water inlet branch G12, and the water outlet branch G22 are all in a strip shape. This helps reduce flow resistance of the heat dissipating lid 5.

In the foregoing disposition manner, layout regularity of the main water inlet path G11, the main water outlet path G21, the water inlet branch G12, and the water outlet branch G22 is improved, an area of an enclosed region is reduced, thereby avoiding increasing an area of the heat dissipating lid 5.

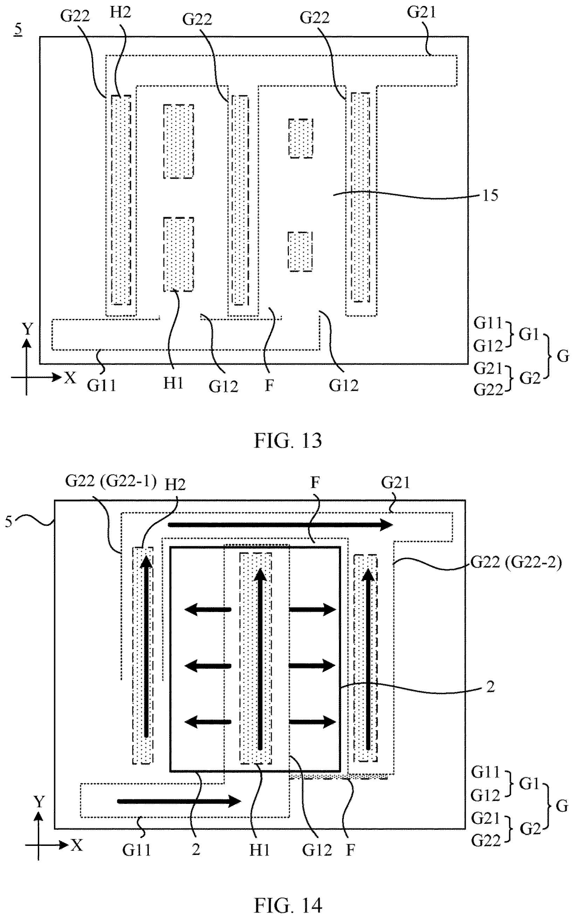

FIG. 10, FIG. 14, FIG. 15, and FIG. 16 each show a top-view structure of a chip package structure. When the heat dissipating lid 5 covers the chip 2, the main water inlet path G11 and the main water outlet path G21 extend in a horizontal direction (namely, the first direction X), and are located on two opposite sides of the chip 2 in the second direction Y The main water inlet path G11 and main water outlet path G21 are staggered with the chip 2, and basically do not overlap the chip 2. The water inlet branch G12 may be located above the chip 2, and covers a part of the chip 2. Optionally, as shown in FIG. 14 to FIG. 16, the water inlet branch G12 covers a middle part of the chip 2. Alternatively, as shown in FIG. 10, the water inlet branch G12 covers an end of the chip 2. Optionally, as shown in FIG. 10, the water outlet branch G22 may be located above the chip 2, and cover a part of the chip 2. Alternatively, as shown in FIG. 14 to FIG. 16, the water outlet branch G22 is located on two opposite sides of the chip 2 in the first direction X. Certainly, a position relationship between the main water inlet path G11, the main water outlet path G21, the water inlet branch G12, and the water outlet branch G22 and the chip 2 is not limited thereto.

In the water inlet channel G1 and the water outlet channel G2, there may be a plurality of manners of disposing the water inlet branch G12 and the water outlet branch G22, and the manner may be selected based on an actual requirement. FIG. 11, FIG. 12, and FIG. 13 respectively show structures of the heat dissipating lid 5.

In some examples, there are a plurality of water outlet branches G22, and one water inlet branch G12 is disposed between two adjacent water outlet branches G22 in the first direction X. The water outlet channel G2 and the water inlet channel G1 are at least arranged in a finger insertion structure.

For example, as shown in FIG. 12, there are two water outlet branches G22, and each water outlet branch G22 is in a strip shape and extends in the second direction Y There is one water inlet branch G12, and the water inlet branch G12 is in a strip shape and extends in the second direction Y In the first direction X, the water inlet branch G12 is located between the two water outlet branches G22. The one water inlet branch G12 and the two water outlet branches G22 are all located between the main water inlet path G11 and the main water outlet path G21, so that the water outlet channel G2 and the water inlet channel G1 are arranged in a finger insertion structure.

For example, as shown in FIG. 13, there are three water outlet branches G22, and each water outlet branch G22 is in a strip shape and extends in the second direction Y There are two water inlet branches G12, and each water inlet branch G12 is in a strip shape and extends in the second direction Y. Each water inlet branch G12 is located between two adjacent water outlet branches G22, and the water outlet branch G22 and the water inlet branch G12 are alternately disposed in sequence in the first direction X. The two water inlet branches G12 and the three water outlet branches G22 are all located between the main water inlet path G11 and the main water outlet path G21, so that the water outlet channel G2 and the water inlet channel G1 are arranged in a finger insertion structure.

Further, when there are more than three water outlet branches G22 and more than two water inlet branches G12, each water outlet branch G22 and each water inlet branch G12 are in a strip shape and extend in the second direction Y, so that the water outlet channel G2 and the water inlet channel G1 are both in a comb shape. The water outlet branch G22 and the water inlet branch G12 may be alternately disposed in sequence in the first direction X, so that the water outlet channel G2 and the water inlet channel G1 are arranged in a finger insertion structure.

In some other examples, the water inlet branch G12 and the water outlet branch G22 are disposed opposite to each other in the second direction Y, and there is a spacing between the water inlet branch G12 and the water outlet branch G22.

For example, as shown in FIG. 11, the water inlet branch G12 and the water outlet branch G22 respectively cover two opposite ends of the chip 2. After entering the lower-layer channel F, the cooling medium in the water inlet branch G12 may flow in the second direction Y, and flow out from the water outlet branch G22 opposite to the water inlet branch G12.

In some other examples, as shown in FIG. 11, there are a plurality of water outlet branches G22 and a plurality of water inlet branches G12. Some of the water outlet branches G22 and some of the water inlet branches G12 may be alternately disposed in sequence in the first direction X. The other water outlet branches G22 and the other water inlet branches G12 may be disposed opposite to each other in a one-to-one correspondence in the second direction Y, and there is a spacing between the water outlet branch G22 and the water inlet branch G12 that are disposed opposite to each other.

FIG. 10 shows a top-view structure of the chip package structure. It may be understood that, when the area of the chip 2 is large or power consumption is high, the water outlet branch G22 and the water inlet branch G12 may be alternately disposed in sequence in the first direction X. In this way, an effective flow path of the cooling medium in the lower-layer channel F can be shortened, and a capability of heat dissipation for the chip 2 can be improved. When the area of the chip 2 is small or power consumption is low, the water inlet branch G12 and the water outlet branch G22 may be disposed opposite to each other, so that there is a spacing between the water inlet branch G12 and the water outlet branch G22. In this way, design difficulty and preparation difficulty of the heat dissipating lid 5 can be reduced.

In some embodiments, in the water outlet channel G2 and the water inlet channel G1, each water inlet branch G12 is connected to at least one water outlet branch G22 through the lower-layer channel F. Optionally, each water inlet branch G12 is connected to one, two, or more water outlet branches G22 through the lower-layer channel F.

Optionally, each water inlet branch G22 is connected to two adjacent water outlet branches G22 through the lower-layer channel F.

For example, in an orthographic projection onto the first surface 1A, at least a part of the chip 2 is located between the water inlet branch G12 and the water outlet branch G22 connected to the water inlet branch G12.

FIG. 14 shows one water inlet branch G12 and two water outlet branches G22 (namely, water outlet branches G22-1 and G22-2). In the first direction X, the water outlet branches G22-1 and G22-2 are respectively located on two sides of the water inlet branch G12. The water inlet branch G12 may be connected to the water outlet branches G22-1 and G22-2 through the lower-layer channel F. FIG. 14 further shows one chip 2. The water inlet branch G12 is located in a middle part of the chip 2, and the water outlet branches G22-1 and G22-2 are located on two opposite sides of the chip 2. One part of the chip 2 is located between the water inlet branch G12 and the water outlet branch G22-1, and the other part is located between the water inlet branch G12 and the water outlet branch G22-2.

In this case, the cooling medium in the water inlet branch G12 flows into the lower-layer channel F from the middle part of the chip 2, one part of the cooling medium flows to the water outlet branch G22-1 and flows out from the water outlet branch G22-1, and the other part flows to the water outlet branch G22-2 and flows out from the water outlet branch G22-2. The part of the cooling medium flowing to the water outlet branch G22-1 dissipates heat only for the part of the chip 2 located between the water outlet branch G22-1 and the water inlet branch G12, and the part of the cooling medium flowing to the water outlet branch G22-2 dissipates heat only for the part of the chip 2 located between the water outlet branch G22-2 and the water inlet branch G12.

FIG. 10 shows two water inlet branches G12 (namely, water inlet branches G12-1 and G12-2) and three water outlet branches G22 (namely, water outlet branches G22-1, G22-2, and G22-3). In the first direction X, the water outlet branches G22-1 and G22-2 are respectively located on two sides of the water inlet branch G12-1. The water inlet branch G12-1 may be connected to the water outlet branches G22-1 and G22-2 through the lower-layer channel F. In the second direction Y, the water inlet branch G12-2 and the water outlet branch G22-3 are disposed opposite to each other, and are connected through the lower-layer channel F. The water inlet branch G12-2 is separated from the water outlet branches G22-1 and G22-2, and the water inlet branch G12-1 is separated from the water outlet branch G22-3. FIG. 10 further shows two chips 2 (namely, chips 2-1 and 2-2). The water inlet branch G12-1 is located in a middle part of the chip 2-2, and the water outlet branch G22-1 and G22-2 are located on two opposite sides of the chip 2-2. One part of the chip 2-2 is located between the water inlet branch G12-1 and the water outlet branch G22-1, and the other part is located between the water inlet branch G12-1 and the water outlet branch G22-2. The water inlet branch G12-2 and the water outlet branch G22-3 are respectively located at two opposite ends of the chip 2-1.

In this case, the cooling medium in the water inlet branch G12-1 flows into the lower-layer channel F from the middle part of the chip 2-2, one part of the cooling medium flows to the water outlet branch G22-1 and flows out from the water outlet branch G22-1, and the other part flows to the water outlet branch G22-2 and flows out from the water outlet branch G22-2. The part of the cooling medium flowing to the water outlet branch G22-1 dissipates heat only for the part of the chip 2-2 located between the water outlet branch G22-1 and the water inlet branch G12-1, and the part of the cooling medium flowing to the water outlet branch G22-2 dissipates heat only for the part of the chip 2-2 located between the water outlet branch G22-2 and the water inlet branch G12-1. The cooling medium in the water inlet branch G12-2 flows into the lower-layer channel F from an end of the chip 2-1, flows to the water outlet branch G22-3, and flows out from the water outlet branch G22-3. The cooling medium flowing to the water outlet branch G22-3 dissipates heat only for the chip 2-1 located between the water outlet branch G22-3 and the water inlet branch G12-2.

In the foregoing disposition manner, a position at which the cooling medium flows into the lower-layer channel F is further control, and the cooling medium is more accurately diverted to a specified cooling region, and flows from the specified cooling region to a specified water outlet branch G22. This effectively shortens an effective flow path of the cooling medium, and enables cooling media flowing through different chips 2 to be different, thereby enabling cooling media in different regions to dissipate heat for different chips 2, and greatly improving a heat dissipation capability.

It may be understood that, in the heat dissipating lid 5, different structures may be disposed in the lower-layer channel F, to improve a heat dissipation capability or a thermal crosstalk prevention capability of the heat dissipating lid 5 for the chip 2.

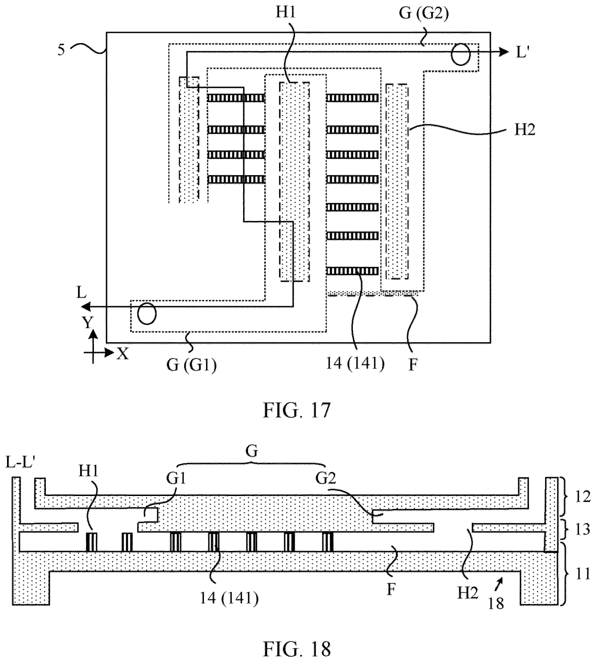

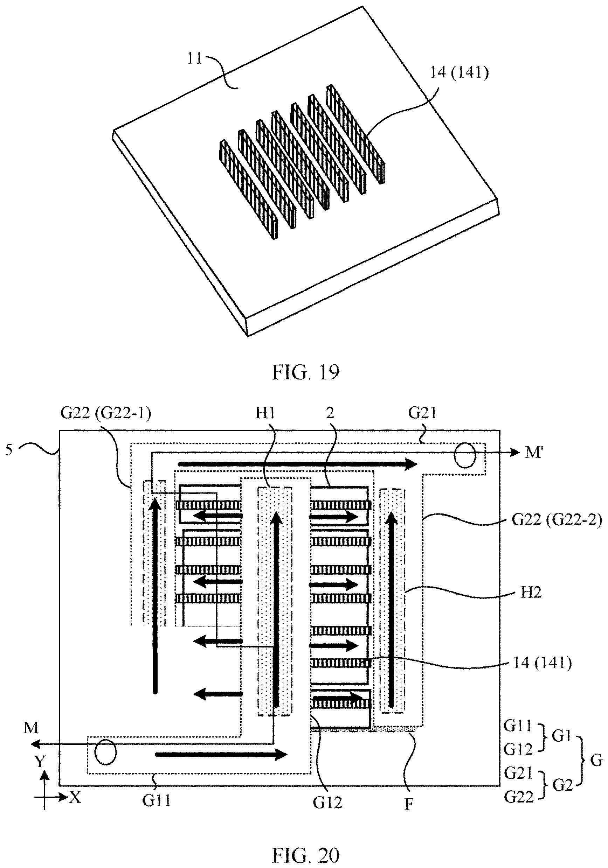

FIG. 17 shows a top-view structure of the heat dissipating lid, FIG. 18 shows a sectional view structure of the heat dissipating lid, and FIG. 19 shows a three-dimensional structure of the bottom plate and the heat dissipation structure.

In some embodiments, as shown in FIG. 17 and FIG. 18, the heat dissipating lid 5 further includes at least one heat dissipation structure 14 located in the lower-layer channel F. As shown in FIG. 17 to FIG. 19, the heat dissipation structure 14 is connected to the bottom plate 11.

Optionally, there may be one, two, three, or more heat dissipation structures 14. When there are a plurality of heat dissipation structures 14, the plurality of heat dissipation structures 14 are disposed at intervals, and arranged in at least one row and/or at least one column.

Because the heat dissipation structure 14 is connected to the bottom plate 11, heat transfer may be performed between the heat dissipation structure 14 and the bottom plate 11. In other words, heat in the bottom plate 11 may be transferred to the heat dissipation structure 14. Heat in the bottom plate 11 may be directly diffused to the lower-layer channel F, and may also be transferred to the heat dissipation structure 14 and then diffused to the lower-layer channel F by using the heat dissipation structure 14, thereby increasing a heat dissipation area. The heat dissipation structure 14 and the intermediate partition plate 13 may be in contact with each other, or may have a specific spacing.

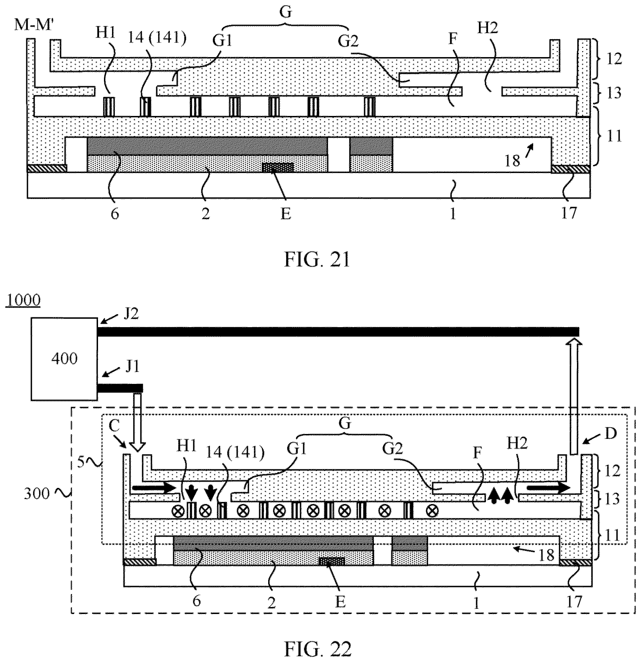

FIG. 20 shows a top-view structure of the chip package structure, and FIG. 21 shows a sectional view structure of the chip package structure. In the chip package structure 300 shown in FIG. 20 and FIG. 21, when the heat dissipating lid 5 covers the chip 2, in an orthographic projection onto the first surface of the package substrate 1, the heat dissipation structure 14 and the chip 2 partially overlap.

For example, the heat dissipation structure 14 covers a part of the chip 2. For example, the heat dissipation structure 14 is located at an edge (which may also be referred to as an outer circumference) and a middle part (which may also be referred to as an inner circumference) of a region occupied by the chip 2. For another example, the heat dissipation structure 14 is centrally disposed in the middle part of the region occupied by the chip 2. For another example, the heat dissipation structure 14 is centrally disposed above a high power consumption region or a local hotspot E of the chip 2.

FIG. 22 shows a structure of the device interconnection system. After heat generated by the chip 2 is transferred to the bottom plate 11, the heat may be directly transferred to the heat dissipation structure 14 covering the chip 2. The cooling medium in the lower-layer channel F may contact the bottom plate 11, to absorb heat diffused from the bottom plate 11 to the lower-layer channel F, and may also contact the heat dissipation structure 14, to absorb heat diffused from the heat dissipation structure 14 to the lower-layer channel F. This effectively increases a heat exchange area, improves heat exchange efficiency, and helps greatly improve a capability of heat dissipation for the chip 2.

A material of the heat dissipation structure 14 includes, for example, a material with high thermal conductivity, for example, a metal material (including but not limited to copper and aluminum). This helps reduce thermal resistance of the heat dissipation structure 14, and further enhance heat transfer from the chip 2 to the lower-layer channel F.

It may be understood that, in the microfluidic channel liquid-cooled technology, in a process in which the cooling medium in the fluid cavity flows from the inlet C to the outlet D, all cooling media need to pass through the fin 7, resulting in large flow resistance of the microfluidic channel liquid-cooled technology. However, in an embodiment of this application, based on disposing positions of the first opening H1 and the second opening H2, a position at which the cooling medium flows into the lower-layer channel F is different from a position at the inlet C, and a position at which the cooling medium flows out of the lower-layer channel F is different from a position at the outlet D, so that the cooling medium in the lower-layer channel F needs to pass through only a part of the heat dissipation structure 14. For example, in the chip package structure 300 shown in FIG. 20, a part of the cooling medium flowing from the water inlet branch G12 to the water outlet branch G22-1 only needs to pass through a part of the heat dissipation structure 14 located between the water inlet branch G12 and the water outlet branch G22-1, and a part of the cooling medium flowing from the water inlet branch G12 to the water outlet branch G22-2 only needs to pass through a part of the heat dissipation structure 14 located between the water inlet branch G12 and the water outlet branch G22-2. In this way, compared with the microfluidic channel liquid-cooled technology, in embodiments of this application, flow resistance of the cooling medium can be effectively reduced, a voltage drop of the cooling medium can be reduced, a flow rate of the cooling medium can be increased, and a heat dissipation capability can be improved.

The heat dissipation structure includes a heat sink and/or a heat sink pin. Optionally, the heat dissipation structure includes only the heat sink. Alternatively, the heat dissipation structure includes only the heat sink pin. Alternatively, the heat dissipation structure includes both the heat sink and the heat sink pin.

In the heat dissipating lid 5 shown in FIG. 17, FIG. 18, and FIG. 23, the heat dissipation structure 14 includes a heat sink 141. The heat sink 141 may also be referred to as a fin, a fin, a heat dissipation fin, or the like. The heat sink 141 extends in a flow direction of the cooling medium in the lower-layer channel F, and at least one heat sink 141 disposed in the lower-layer channel F divides the lower-layer channel F into a plurality of flow channels.

When there are a plurality of heat sinks 141, the plurality of heat sinks are arranged at intervals in a direction intersecting the flow direction of the cooling medium. For example, the flow direction of the cooling medium in the lower-layer channel F is the first direction X. In this case, each heat sink 141 extends in the first direction X, and the plurality of heat sinks 141 are arranged at intervals, for example, in the second direction Y, in one column. Lengths, widths, and heights of different heat sinks 141 are, for example, the same, and spacings between any two adjacent heat sinks 141 are, for example, the same.

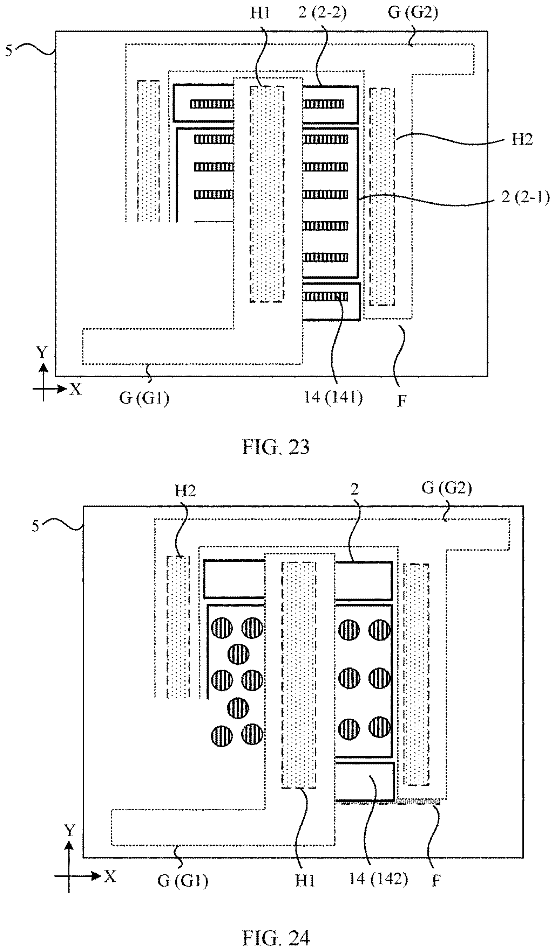

In the heat dissipating lid 5 shown in FIG. 24, the heat dissipation structure 14 includes a heat dissipating pin 142. The heat dissipation pin 142 may also be referred to as a pin fin or the like. In the orthographic projection onto the first surface 1A, the heat dissipation pin 142 is in a shape of, for example, a circle, an ellipse, or a square.

When there are a plurality of heat dissipation pins 142, for example, the plurality of heat dissipation pins 142 are arranged in an array, that is, the plurality of heat dissipation pins 142 may be arranged in a plurality of rows and a plurality of columns. Each row of heat dissipation pins includes a plurality of heat dissipation pins 142, and each column of heat dissipation pins includes a plurality of heat dissipation pins.

In some examples, power consumption of the chip 2 is positively correlated with distribution density of the heat dissipation structure 14. In other words, lower power consumption of the chip 2 indicates lower distribution density of the heat dissipation structure 14, and higher power consumption of the chip 2 indicates higher distribution density of the heat dissipation structure 14.

The "distribution density of the heat dissipation structure 14" is, for example, a distribution quantity of the heat dissipation structures 14 per unit area, or an area proportion of the heat dissipation structure 14 per unit area. Correspondingly, as the power consumption of the chip 2 increases, the distribution quantity of the heat dissipation structures 14 or the area proportion of the heat dissipation structure 14 gradually increases per unit area. As the power consumption of the chip 2 decreases, the distribution quantity of the heat dissipation structures 14 or the area proportion of the heat dissipation structure 14 gradually decreases per unit area.

In the foregoing disposition manner, when the power consumption of the chip 2 is low and less heat is generated by the chip, the distribution density of the heat dissipation structure 14 can be reduced, flow resistance can be reduced, a flow rate of the cooling medium can be increased, and a good capability of heat dissipation for the chip 2 can be ensured. When the power consumption of the chip 2 is high and more heat is generated by the chip, the distribution density of the heat dissipation structure 14 can be increased, a heat exchange area can be increased, heat exchange efficiency can be improved, and effective heat dissipation for the chip 2 with high power consumption and density can be ensured.

Optionally, the heat dissipation structure 14 and the bottom plate 11 are in an integrated structure. In other words, the heat dissipation structure 14 and the bottom plate 11 are integrally formed, and are not separated. This helps improve structural stability between the heat dissipation structure 14 and the bottom plate 11, and facilitates assembly of the heat dissipating lid 5.

It may be understood that an area of the chip 2 covered by the lower-layer channel F may cooperate with an area of the chip 2 covered by the heat dissipation structure 14, to further improve heat dissipation performance.

For example, in the chip package structure shown in FIG. 20, the lower-layer channel F completely covers each chip 2 (which may also be referred to as covering 100% of the chip 2), so that the cooling medium flows over the entire chip 2 to dissipate heat for the entire chip 2. In the chip package structure shown in FIG. 23, the lower-layer channel F completely covers the chip 2-1 located in the middle part (for example, the chip 2-1 is a high power consumption chip), and covers a part of the chip 2-2 located around the chip 2-1 (for example, the chip 2-2 is a low power consumption chip, and the lower-layer channel F covers 50% of the chip 2-2), and an area of each chip 2 covered by the heat dissipation structure 14 is reduced. By using the shrinkage design, the flow of the cooling medium above the chip 2-1 can be effectively increased (by about 30%, through verification), and a temperature of the chip 2-1 can be effectively lowered (by about 4°C, through verification).

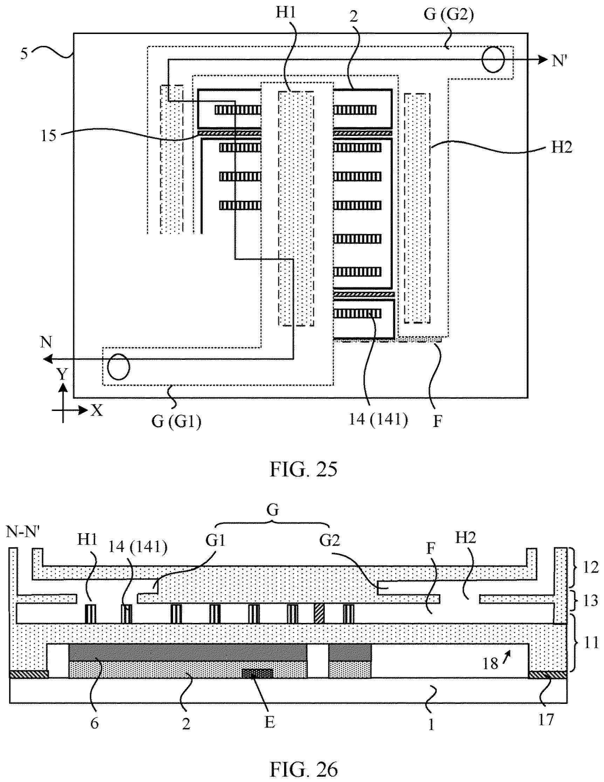

FIG. 25 shows a top-view structure of the chip package structure, and FIG. 26 shows a sectional view structure of the chip package structure.

In some other embodiments, with reference to FIG. 25 and FIG. 26, there are a plurality of chips 2. The heat dissipating lid 5 further includes at least one thermal insulation structure (or referred to as an air gap structure) 15 located in the lower-layer channel F, where the thermal insulation structure 15 connects the bottom plate 11 and the intermediate partition plate 13.

Optionally, there may be one, two, three, or more thermal insulation structures 15. Each thermal insulation structure 15 divides the lower-layer channel F into different flow channels. Because the thermal insulation structure 15 is connected to the bottom plate 11 and the intermediate partition plate 13, different flow channels located on two opposite sides of the thermal insulation structure 15 are separated from each other, and cannot be connected by using the thermal insulation structure 15.

In the chip package structures shown in FIG. 10, FIG. 16, and FIG. 25, when the heat dissipating lid 5 covers the chip 2, in the orthographic projection onto the first surface 1A, the thermal insulation structure 15 is located between two adjacent chips 2. The thermal insulation structure 15 divides a part of the lower-layer channel F corresponding to the two adjacent chips 2 into two flow channels, so that in the lower-layer channel F, cooling media located above the two adjacent chips 2 are separated and cannot flow to each other. The thermal insulation structure 15 has thermal insulation performance. This can greatly reduce heat exchange of cooling media located above two adjacent chips 2 by using the thermal insulation structure 15, and prevent thermal crosstalk between the two adjacent chips 2 by using the heat dissipating lid 5.

It may be understood that different chips 2 have different temperature specifications and different power consumption. In an embodiment of this application, the thermal insulation structure 15 is disposed, so that thermal isolation can be performed on adjacent chips 2. This effectively reduces thermal crosstalk between chips 2 located on two opposite sides of the thermal insulation structure 15, and improves heat dissipation performance.

In the chip package structure shown in FIG. 10, two chips 2 (namely, the chips 2-1 and 2-2) are shown. The chip 2-1 is, for example, a storage chip, and the chip 2-2 is, for example, a computing chip or an image processing chip. The chip 2-1 and the chip 2-2 are usually adjacently disposed. An area of the chip 2-1 is small, and a temperature specification of the chip 2-1 is, for example, 95°C. An area of the chip 2-2 is large, and a temperature specification of the chip 2-2 is, for example, 105°C. The temperature specifications of chip 2-1 and chip 2-2 differ greatly. FIG. 10 further shows one thermal insulation structure 15. The thermal insulation structure 15 is located between the chip 2-1 and the chip 2-2, and divides the lower-layer channel F into two separated flow channels, so that the water inlet branch G12-1 is connected to the water outlet branches G22-1 and G22-2 through one of the flow channels, and the water inlet branch G12-2 is connected to the water outlet branch G22-3 through the other flow channel. In this way, the chip 2-1 and the chip 2-2 can be effectively prevented from performing thermal crosstalk through the lower-layer channel F.

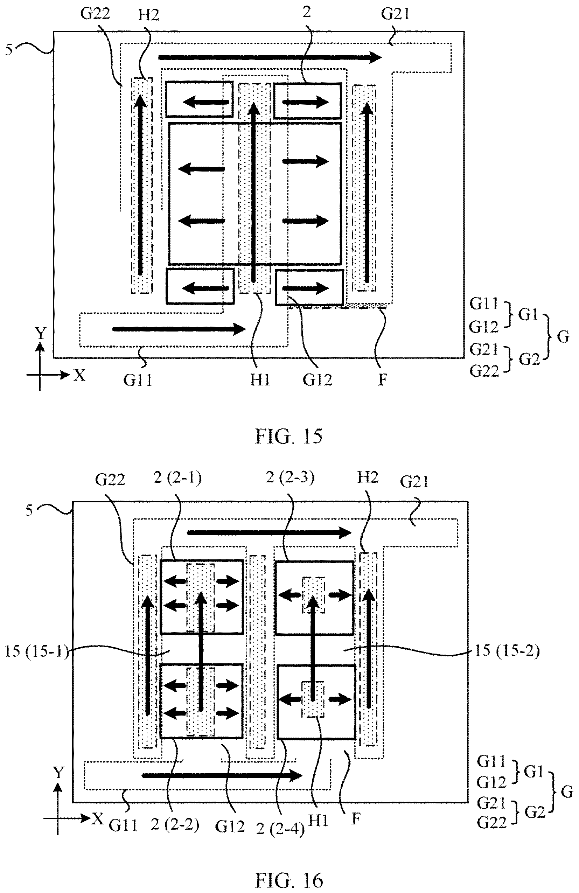

In the chip package structure 300 shown in FIG. 16, four chips 2 (namely, chips 2-1, 2-2, 2-3, and 2-4) are shown. The four chips 2 have similar areas, but different power consumption. FIG. 16 further shows two thermal insulation structures 15 (namely, thermal insulation structures 15-1 and 15-2). The thermal insulation structure 15-1 is located between the chip 2-1 and the chip 2-2, and divides a part of the lower-layer channel F corresponding to the chip 2-1 and the chip 2-2 into two flow channels. The thermal insulation structure 15-2 is located between the chip 2-3 and the chip 2-4, and divides a part of the lower-layer channel F corresponding to the chip 2-3 and the chip 2-4 into two flow channels. Each water inlet branch G12 is connected to the water outlet branch G22 through a corresponding flow channel. In this way, the chip 2-1 and the chip 2-2 can be effectively prevented from performing thermal crosstalk through the lower-layer channel F, and the chip 2-3 and the chip 2-4 can be effectively prevented from performing thermal crosstalk through the lower-layer channel F.

The thermal insulation structure 15 is in, for example, a strip shape, and an extension direction of the thermal insulation structure 15 intersects an arrangement direction of two adjacent chips 2.

For example, in the chip package structure 300 shown in FIG. 10, the chip 2-1 and the chip 2-2 are sequentially arranged in the first direction X, and the thermal insulation structure 15 extends in the second direction Y For another example, in the chip package structure 300 shown in FIG. 16, the chip 2-1 and the chip 2-2 are sequentially arranged in the second direction Y, the chip 2-3 and the chip 2-4 are sequentially arranged in the second direction Y, and both the thermal insulation structure 15-1 and the thermal insulation structure 15-2 extend in the first direction X.

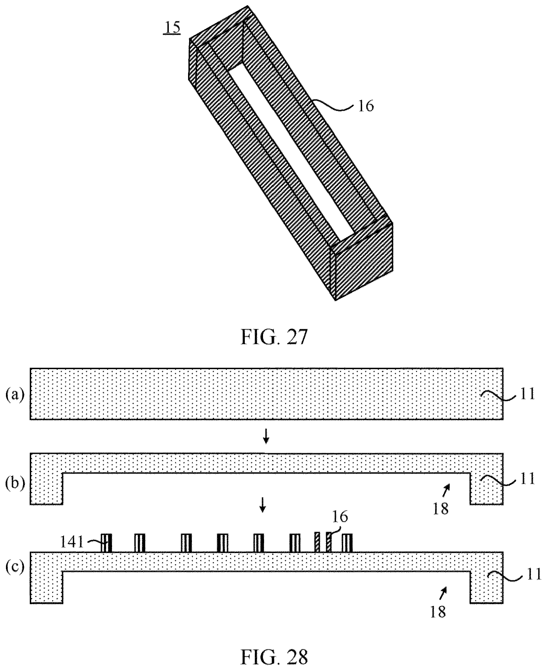

FIG. 27 shows a structure of the thermal insulation structure 15. As shown in FIG. 27, the thermal insulation structure 15 includes a plurality of separators 16, and the plurality of separators 16 are head-to-tail connected in sequence, to form a ring structure. For example, FIG. 27 shows four separators 16. The four separators 16 are head-to-tail connected in sequence, to form a square ring structure, where the square ring structure is further in a strip shape.

The plurality of separators 16 connects the bottom plate 11 and the intermediate partition plate 13, to form an air gap (air gap) between the bottom plate 11 and the intermediate partition plate 13. The plurality of separators 16 may divide a part of the lower-layer channel F corresponding to the two adjacent chips 2, to prevent the cooling medium in the lower-layer channel F from flowing into the air gap, and the air gap may form thermal isolation for a flow channel located above the two adjacent chips 2.

The thermal insulation structure 15 has a simple structure and is easy to prepare and assemble.

Optionally, the plurality of separators 16 are in an integrated structure. For example, in an embodiment of this application, a metal column (for example, a copper column) can be machined and grooved, to obtain a plurality of separators 16 in an integrated structure.

Optionally, the plurality of separators 16 and the bottom plate 11 are in an integrated structure. In other words, the separator 16 and the bottom plate 11 are integrally formed, and are not separated. This helps improve structural stability between the separator 16 and the bottom plate 11, and facilitates assembly of the heat dissipating lid 5.

The heat dissipating lid 5 may be directly soldered to the chip 2 for integrated packaging, as shown in FIG. 7 and FIG. 8. In this case, the heat dissipating lid 5 may also be referred to as a water-cooled plate. Certainly, there may be another integration manner between the heat dissipating lid 5 and the package substrate 1. For example, as shown in FIG. 18 and FIG. 21, the heat dissipating lid 5 is connected to the package substrate 1 through an adhesive layer 17.

As shown in FIG. 21, a groove 18 is provided on a side that is of the bottom plate 11 and that faces the package substrate 1, the chip 2 is located in the groove 18, and the bottom plate 11 is connected to the first surface 1A of the package substrate 1 through, for example, the adhesive layer (whose material is, for example, an AD adhesive) 17. The heat dissipating lid 5 can not only dissipate heat for the chip 2, but also protect the chip 2. In addition, additional heat sinks can be avoided.

Because the heat dissipating lid 5 mainly includes three basic structures: the bottom plate 11, the intermediate partition plate 13, and the cover 12, when the heat dissipating lid 5 is assembled, the bottom plate 11 and the intermediate partition plate 13 may be fixedly connected first to implement sealing of the lower-layer channel F, and then the cover 12 and the intermediate partition plate 13 are fixedly connected to implement sealing of the upper-layer channel G. Alternatively, the cover 12 and the intermediate partition plate 13 may be fixedly connected first to implement sealing of the upper-layer channel G, and then the bottom plate 11 and the intermediate partition plate 13 are fixedly connected to implement sealing of the lower-layer channel F. With reference to the accompanying drawings, the following describes a process of preparing the heat dissipating lid 5 and a process of packaging the heat dissipating lid 5, the chip 2, and the packaging substrate 1 by using an example in which the bottom plate 11 and the intermediate partition plate 13 are fixedly connected first, and then the cover 12 and the intermediate partition plate 13 are fixedly connected.

S100: First, separately machine the bottom plate 11, the intermediate partition plate 13, and the cover 12.

Optionally, a process of machining the bottom plate 11 is shown in FIG. 28.

As shown in (a) in FIG. 28, one bottom plate 11 is provided, and a material of the bottom plate 11 includes but is not limited to copper.

As shown in (b) in FIG. 28, the groove 18 is provided at the bottom of the bottom plate 11, and the groove 18 is configured to enclose the chip.

When the heat dissipation structure 14 (using the heat sink 141 as an example) is disposed in the lower-layer channel F, as shown in (c) in FIG. 28, a plurality of heat sinks 141 disposed at intervals may be formed on the top of the bottom plate 11 by using a serrate teeth method.

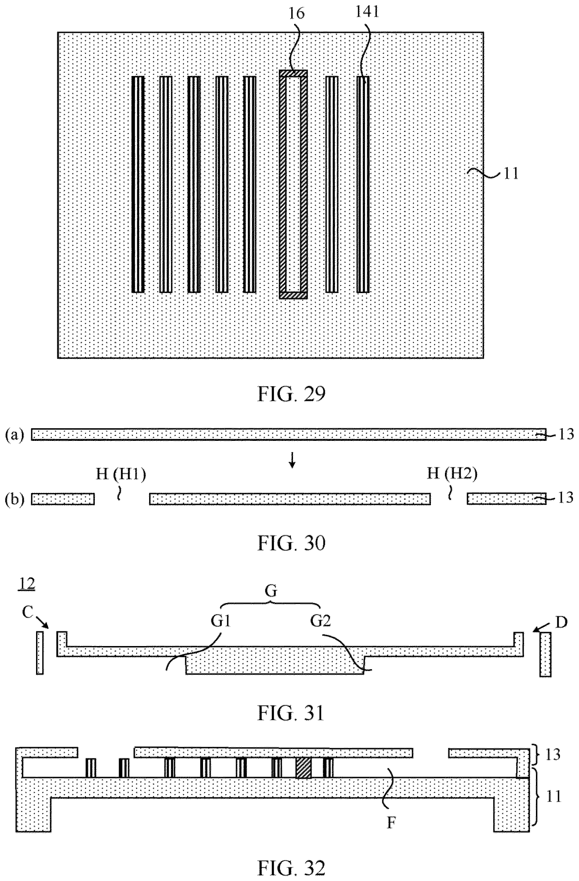

When the thermal insulation structure 15 is disposed in the lower-layer channel F, as shown in (c) in FIG. 28 and FIG. 29, a plurality of separators 16 may be formed on the top of the bottom plate 11 by using the serrate teeth method, and then two adjacent separators 16 are soldered by using a soldering process, so that the plurality of separators 16 enclose an air gap. Certainly, alternatively, a metal column (for example, a copper column) may be machined and grooved to form an air gap, and then the groove is soldered to the bottom plate 11.

Optionally, a process of machining the intermediate partition plate 13 is shown in FIG. 30.

As shown in (a) in FIG. 30, one intermediate partition plate 13 is provided, and a material of the intermediate partition plate 13 includes but is not limited to copper. A thickness of the intermediate partition plate 13 includes but is not limited to 1 mm.

As shown in (b) in FIG. 30, a plurality of openings H are provided at a preset position of the intermediate partition plate 13, where the plurality of openings H include the first opening H1 used to connect the water inlet channel G1 and the lower-layer channel F and the second opening H2 used to connect the lower-layer channel F and the water outlet channel G2. An area of each opening H is greater than or equal to 5 mm × 5 mm (namely, 25 mm²). Certainly, the area of each opening H is not limited thereto.

Optionally, a process of machining the cover 12 is shown in FIG. 31.

One cover 12 is provided, and a material of the cover 12 includes but is not limited to copper.

As shown in FIG. 31, the inlet C and the outlet D are provided at a preset position of the cover 12. In addition, a plurality of baffle plates may be formed at the bottom of the cover 12 by using the serrate teeth method, and the plurality of baffle plates are configured to enclose the water inlet channel G1 and the water outlet channel G2. A diameter range of the inlet C includes but is not limited to 3 mm to 10 mm, a diameter range of the outlet D includes but is not limited to 3 mm to 10 mm, a height range of the water inlet channel G1 includes but is not limited to 1 mm to 5 mm, a width of the water inlet channel G1 is, for example, greater than or equal to 5 mm, a height range of the water outlet channel G2 includes but is not limited to 1 mm to 5 mm, and a width of the water outlet channel G2 is, for example, greater than or equal to 5 mm.

S200: As shown in FIG. 32, the bottom plate 11 and the intermediate partition plate 13 may be soldered together by using a soldering process (including but not limited to high temperature diffusion soldering, brazing soldering, and the like), so as to implement sealing of the lower-layer channel F.

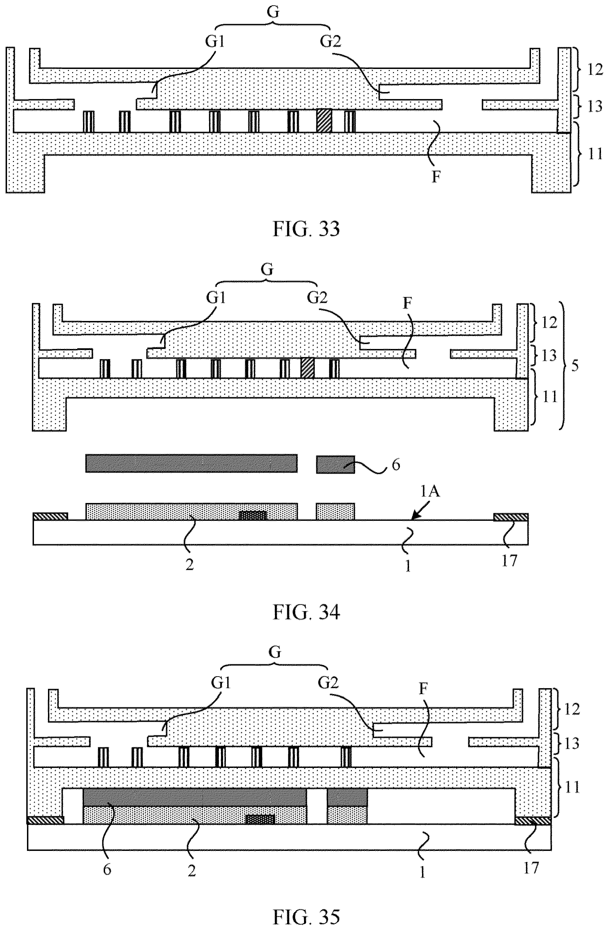

S300: As shown in FIG. 33, the cover 12 may be soldered to the intermediate partition plate 13 by using the soldering process (including but not limited to high temperature diffusion soldering, brazing soldering, and the like), so as to implement sealing of the upper-layer channel G, and obtain the heat dissipating lid 5.

S400: As shown in FIG. 34, connect the chip 2 and the adhesive layer 17 on the first surface 1A of the package substrate 1, and provide the first thermal interface material layer 6 and the heat dissipating lid 5.

S500: As shown in FIG. 35, integrate the heat dissipating lid 5, the chip 2, the first thermal interface material layer 6, and the package substrate 1 into one package by using a packaging process, to obtain the chip package structure.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this disclosure shall fall within the protection scope of this application. Therefore, the protection scope of this application shall be subject to the protection scope of the claims.

## Claims

1. A chip package structure, wherein the chip package structure comprises:
a chip; and
a heat dissipating lid, covering the chip, wherein
the heat dissipating lid comprises:
a bottom plate;
a cover, located on a side that is of the bottom plate and that is away from the chip, and connected to the bottom plate; and
an intermediate partition plate, connected between the bottom plate and the cover, wherein a lower-layer channel is provided between the intermediate partition plate and the bottom plate, an upper-layer channel is provided between the intermediate partition plate and the cover, the upper-layer channel comprises a water inlet channel and a water outlet channel that are spaced from each other, the intermediate partition plate has a first opening and a second opening, the first opening connects the water inlet channel and the lower-layer channel, the second opening connects the lower-layer channel and the water outlet channel, and the lower-layer channel covers at least a part of the chip.

2. The chip package structure according to claim 1, wherein the water inlet channel comprises a main water inlet path and at least one water inlet branch connected to the main water inlet path, and the water outlet channel comprises a main water outlet path and at least one water outlet branch connected to the main water outlet path, wherein
at least one first opening is provided on a part that is of the intermediate partition plate and that is opposite to the water inlet branch; and
at least one second opening is provided on a part that is of the intermediate partition plate and that is opposite to the water outlet branch.

3. The chip package structure according to claim 2, wherein both the main water inlet path and the main water outlet path extend in a first direction and are disposed opposite to each other; and
both the water inlet branch and the water outlet branch extend in a second direction and are located between the main water inlet path and the main water outlet path, wherein
the first direction and the second direction intersect, and are both parallel to a plane on which the intermediate partition plate is located.

4. The chip package structure according to claim 3, wherein there are a plurality of the water outlet branches, and one water inlet branch is disposed between two adjacent water outlet branches in the first direction; and
the water outlet channel and the water inlet channel are at least arranged in a finger insertion structure.

5. The chip package structure according to claim 3, wherein the water inlet branch and the water outlet branch are disposed opposite to each other in the second direction, and there is a spacing between the water inlet branch and the water outlet branch.

6. The chip package structure according to claim 2, wherein the water inlet branch is connected to the at least one water outlet branch through the lower-layer channel; and
in an orthographic projection onto a plane on which the intermediate partition plate is located, at least a part of the chip is located between the water inlet branch and the water outlet branch connected to the water inlet branch.

7. The chip package structure according to claim 1, wherein the heat dissipating lid further comprises at least one heat dissipation structure located in the lower-layer channel, and the heat dissipation structure is connected to the bottom plate; and
in an orthographic projection onto a plane on which the intermediate partition plate is located, the heat dissipation structure partially overlaps the chip.

8. The chip package structure according to claim 7, wherein the heat dissipation structure comprises a heat sink, and the heat sink extends in a flow direction of a cooling medium in the lower-layer channel; and/or
the heat dissipation structure comprises a heat dissipation pin.

9. The chip package structure according to claim 8, wherein there are a plurality of the heat sinks, and the plurality of the heat sinks are arranged at intervals in a direction intersecting the flow direction of the cooling medium; or
there are a plurality of the heat dissipation pins, and the plurality of the heat dissipation pins are arranged in an array.

10. The chip package structure according to claim 7, wherein the heat dissipation structure and the bottom plate are in an integrated structure.

11. The chip package structure according to claim 1, wherein there are a plurality of the chips;
the heat dissipating lid further comprises at least one thermal insulation structure located in the lower-layer channel, wherein the thermal insulation structure connects the bottom plate and the intermediate partition plate; and
in an orthographic projection onto a plane on which the intermediate partition plate is located, the thermal insulation structure is located between two adjacent chips, and the thermal insulation structure divides a part of the lower-layer channel corresponding to the two adjacent chips into different flow channels.

12. A device interconnection system, wherein the device interconnection system comprises:
a circuit board; and
the chip package structure according to any one of claims 1 to 11, wherein the chip package structure is connected to the circuit board.

13. A heat dissipating lid, wherein the heat dissipating lid comprises:
a bottom plate;
a cover, located on a side of the bottom plate and connected to the bottom plate; and
an intermediate partition plate, connected between the bottom plate and the cover, wherein a lower-layer channel is provided between the intermediate partition plate and the bottom plate, an upper-layer channel is provided between the intermediate partition plate and the cover, the upper-layer channel comprises a water inlet channel and a water outlet channel that are spaced from each other, the intermediate partition plate has a first opening and a second opening, the first opening connects the water inlet channel and the lower-layer channel, and the second opening connects the lower-layer channel and the water outlet channel.

14. The heat dissipating lid according to claim 13, wherein the water inlet channel comprises a main water inlet path and at least one water inlet branch connected to the main water inlet path, and the water outlet channel comprises a main water outlet path and at least one water outlet branch connected to the main water outlet path, wherein
at least one first opening is provided on a part that is of the intermediate partition plate and that is opposite to the water inlet branch; and
at least one second opening is provided on a part that is of the intermediate partition plate and that is opposite to the water outlet branch.

15. The heat dissipating lid according to claim 14, wherein there are a plurality of the water outlet branches, and one water inlet branch is disposed between two adjacent water outlet branches in the first direction; and
the water outlet channel and the water inlet channel are at least arranged in a finger insertion structure.
